(19) Europäisches Patentamt
European Patent Office
Office européen des brevets

(11) EP 3 037 832 B1

(12) FASCICULE DE BREVET EUROPEEN

(45) Date de publication et mention
de la délivrance du brevet:
22.01.2020 Bulletin 2020/04

(51) Int Cl.:
G01R 21/06 (2006.01)     G01R 21/133 (2006.01)
G01R 19/25 (2006.01)     G01R 22/06 (2006.01)

(21) Numéro de dépôt: 15202216.6

(22) Date de dépôt: 22.12.2015

(54) DISPOSITIF ET PROCÉDÉ DE SURVEILLANCE D'UNE TENSION OU D'UNE INTENSITÉ DE COURANT, SYSTÈME DE SURVEILLANCE D'UN TABLEAU ÉLECTRIQUE, ARMOIRE ÉLECTRIQUE ET POSTE DE TRANSFORMATION ASSOCIÉS

VERFAHREN UND VORRICHTUNG ZUR ÜBERWACHUNG EINER SPANNUNG ODER EINER STROMSTÄRKE, ENTSPRECHENDES ÜBERWACHUNGSSYSTEM EINER ELEKTRISCHEN SCHALTTAFEL, ENTSPRECHENDER SCHALTSCHRANK UND ENTSPRECHENDE TRANSFORMATIONSEINHEIT

DEVICE AND METHOD FOR MONITORING A VOLTAGE OR AN INTENSITY OF CURRENT, RELATED SYSTEM FOR MONITORING AN ELECTRICAL PANEL, ELECTRICAL CABINET AND TRANSFORMING STATION

(84) Etats contractants désignés:
AL AT BE BG CH CY CZ DE DK EE ES FI FR GB GR HR HU IE IS IT LI LT LU LV MC MK MT NL NO PL PT RO RS SE SI SK SM TR

(30) Priorité: 22.12.2014 FR 1463163

(43) Date de publication de la demande:
29.06.2016 Bulletin 2016/26

(73) Titulaire: Schneider Electric Industries SAS
92500 Rueil-Malmaison (FR)

(72) Inventeurs:
• MOLLIER, Christophe
38050 GRENOBLE Cedex 09 (FR)
• GAILLARD, Maxime
38050 GRENOBLE Cedex 09 (FR)

(74) Mandataire: Lavoix
2, place d'Estienne d'Orves
75441 Paris Cedex 09 (FR)

(56) Documents cités:
EP-A1- 2 354 799     EP-A1- 2 685 267
EP-A1- 2 730 929     EP-A1- 2 873 981
WO-A1-2013/017663     FR-A1- 2 991 057
FR-A1- 3 007 143     US-B1- 6 734 658
US-B1- 7 109 699

EP 3 037 832 B1

**Description**

La présente invention concerne un dispositif électronique de surveillance d'une grandeur électrique parmi une tension et une intensité relative à un courant alternatif circulant dans un conducteur électrique, le courant alternatif comportant au moins une phase.

Le dispositif de surveillance comprend un module de mesure configuré pour mesurer au moins une valeur de la grandeur électrique, un émetteur-récepteur radioélectrique, et un module d'émission relié à l'émetteur-récepteur radioélectrique.

La présente invention concerne également un système électronique de surveillance d'un tableau électrique comportant au moins un conducteur électrique primaire de départ et au moins un conducteur électrique secondaire de départ, chaque conducteur secondaire de départ étant connecté électriquement à un conducteur primaire de départ correspondant.

Le système de surveillance comprend de tels dispositifs de surveillance, à savoir un premier dispositif électronique de surveillance de la tension de chaque conducteur électrique primaire de départ, et au moins un deuxième dispositif électronique de surveillance de l'intensité du courant alternatif circulant dans chaque conducteur électrique secondaire.

La présente invention concerne également une armoire électrique comprenant un tableau électrique comportant des conducteurs électriques de départ, et un tel système de surveillance.

La présente invention concerne également un poste de transformation d'un courant électrique présentant une première tension alternative en un courant électrique présentant une deuxième tension alternative, ce poste de transformation comprenant une telle armoire électrique, un tableau d'arrivée comportant au moins un conducteur électrique d'arrivée propre à être relié à un réseau électrique, le conducteur d'arrivée présentant la première tension alternative, le tableau de l'armoire formant un tableau de départ dont les conducteurs de départ correspondants présentent la deuxième tension alternative. Le poste de transformation comporte en outre un transformateur électrique connecté entre le tableau d'arrivée et le tableau de départ, le transformateur étant propre à transformer le courant présentant la première tension alternative en le courant présentant la deuxième tension alternative.

La présente invention concerne également un procédé de surveillance d'une grandeur électrique parmi une tension et une intensité relative à un courant alternatif circulant dans un conducteur électrique.

On connaît du document WO 2013/017663 A1 un système de surveillance du type précité. Ce système de surveillance permet en particulier de mesurer l'énergie électrique du courant circulant dans des conducteurs secondaires reliés à un conducteur primaire, les conducteurs secondaires correspondant à des conducteurs de départ d'un tableau de départ et présentant sensiblement la même tension que le conducteur primaire. Le module primaire forme un dispositif de surveillance de la tension du conducteur primaire, et chaque module secondaire forme un dispositif de surveillance de l'intensité du courant circulant dans le conducteur secondaire correspondant.

Le module primaire mesure régulièrement la tension du conducteur primaire, puis transmet régulièrement un premier message contenant une donnée de synchronisation, ainsi que les valeurs mesurées de ladite tension. Chaque module secondaire se synchronise alors à l'aide de la donnée de synchronisation reçue ; mesure, de manière synchronisée avec le module primaire, l'intensité du courant circulant dans le conducteur secondaire correspondant ; puis calcule l'énergie du courant circulant dans ledit conducteur secondaire à l'aide des valeurs mesurées d'intensité et des valeurs de tension contenues dans le premier message. Chaque module secondaire envoie ensuite, à destination d'un module de centralisation et selon un mécanisme de jeton distribué entre les modules secondaires, un deuxième message contenant l'identifiant du module secondaire correspondant et l'énergie calculée par le module secondaire, par exemple sous forme de différentes valeurs de compteurs d'énergie.

EP 2 685 267 A1, FR 2 991 057 A1 et FR 3 007 143 A1 décrivent chacun un système de surveillance d'un tableau électrique, le système comportant un premier dispositif de surveillance de la tension de chaque conducteur primaire de départ, des deuxièmes dispositifs de surveillance de l'intensité du courant alternatif circulant dans des conducteurs secondaires de départ et un dispositif de centralisation.

US 6,734,658 B1 décrit une sonde de tension propre à mesurer une différence de tension entre des conducteurs dans un système triphasée, à déterminer une différence de phase et une séquence de phase pour chacun des conducteurs.

Toutefois, la mesure de l'intensité, puis le calcul de l'énergie sont relativement consommateurs en énergie électrique, et ceci engendre certaines limitations de fonctionnement d'un tel système de surveillance, d'autant plus que chaque module secondaire est autoalimenté à partir d'un tore disposé autour du conducteur secondaire correspondant.

Le but de l'invention est de proposer des dispositifs de surveillance de la tension, et respectivement de l'intensité d'un courant alternatif circulant dans un conducteur électrique, et un système de surveillance comprenant de tels dispositifs, permettant de remédier au problème précité.

A cet effet, l'invention a pour objet un dispositif électronique de surveillance selon la revendication 1.

Suivant un autre aspect avantageux de l'invention, le dispositif électronique de surveillance est selon la revendication 2.

L'invention a également pour objet un système électronique de surveillance d'un tableau électrique, selon la revendication 3.

Suivant d'autres aspects avantageux de l'invention, le système électronique de surveillance est selon l'une quelconque des revendications 4 à 7.

L'invention a également pour objet une armoire électrique selon la revendication 8.

L'invention a également pour objet un poste de transformation selon la revendication 9.

L'invention a également pour objet un procédé de de surveillance selon la revendication 10.

Ces caractéristiques et avantages de l'invention apparaîtront à la lecture de la description qui va suivre, donnée uniquement à titre d'exemple non limitatif, et faite en référence aux dessins annexés, sur lesquels :

- la figure 1 est une représentation schématique d'un poste de transformation comprenant un premier tableau, un deuxième tableau connecté au premier tableau par l'intermédiaire d'un transformateur et un système de surveillance du deuxième tableau,
- la figure 2 est une représentation schématique du système de surveillance de la figure 1 selon un premier mode de réalisation, le système de surveillance comprenant un premier dispositif de surveillance de la tension, une pluralité de deuxièmes dispositifs de surveillance de l'intensité et un dispositif de centralisation,
- la figure 3 est une représentation schématique du deuxième dispositif de la figure 2,
- la figure 4 est un organigramme des étapes d'un procédé de surveillance selon l'invention, mises en œuvre par le premier dispositif de la figure 2,
- la figure 5 est un organigramme des étapes du même procédé de surveillance, mises en œuvre par les deuxièmes dispositifs des figures 2 et 3,
- la figure 6 est un organigramme des étapes du même procédé de surveillance, mises en œuvre par le dispositif de centralisation de la figure 2,
- la figure 7 est un chronogramme représentant les instants d'émission et de réception d'un premier message, celui-ci étant émis par le premier dispositif à destination des deuxièmes dispositifs,
- la figure 8 est un chronogramme représentant les périodes temporelles pour lesquelles des coefficients d'une décomposition en série de Fourier de la tension, et respectivement de l'intensité, sont déterminés et également les instants temporels de préparation du premier message, d'émission du premier message et de calcul de l'énergie électrique, et
- la figure 9 est une vue analogue à celle de la figure 2 selon un deuxième mode de réalisation.

Dans la suite de la description, l'expression « sensiblement égal à » définit une relation d'égalité à plus ou moins 10 %, de préférence à plus ou moins 5 %.

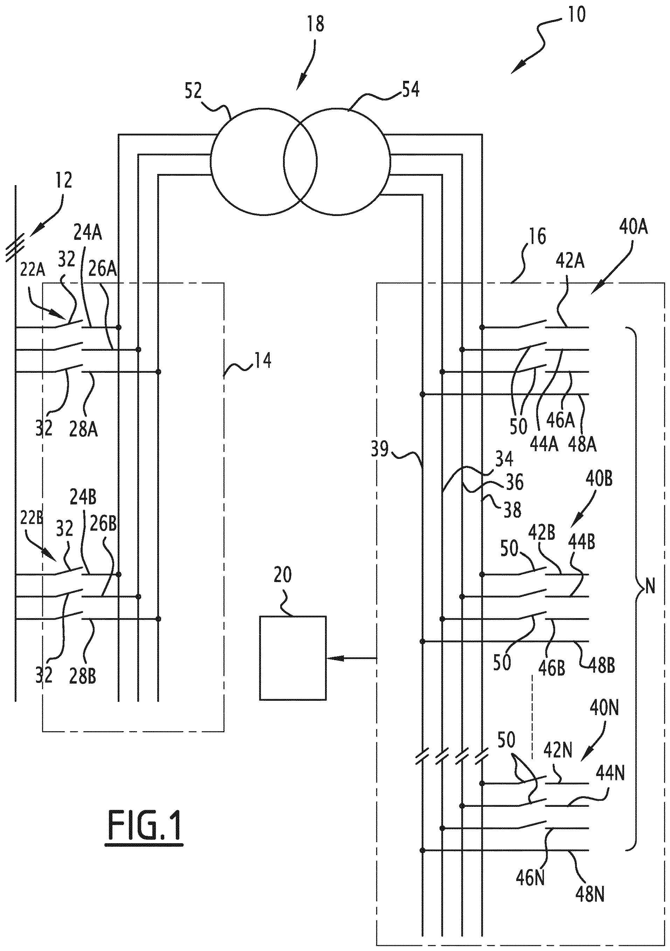

Sur la figure 1, un poste de transformation 10 connecté à un réseau électrique 12 comprend un premier tableau 14, également appelé tableau d'arrivée, un deuxième tableau 16, également appelé tableau de départ, un transformateur électrique 18 connecté entre le premier tableau et le deuxième tableau et un système 20 de surveillance du deuxième tableau.

En variante, une armoire électrique, non représentée, comporte le deuxième tableau 16 et le système de surveillance 20. Autrement dit, l'armoire électrique comporte les éléments du poste de transformation 10 à l'exception du transformateur électrique 18 et du premier tableau 14, le deuxième tableau 16 étant par exemple alimenté directement en basse tension.

Le poste de transformation 10 est propre à transformer le courant électrique délivré par le réseau 12 et présentant une première tension alternative, en un courant électrique présentant une deuxième tension alternative.

Le réseau électrique 12 est un réseau alternatif, tel qu'un réseau triphasé. Le réseau électrique 12 est, par exemple, un réseau moyenne tension, c'est-à-dire de tension supérieure à 1 000 V et inférieure à 50 000 V. La première tension triphasée est alors une moyenne tension. En variante, le réseau électrique 12 est un réseau haute tension, c'est-à-dire de tension supérieure à 50 000 V.

Le premier tableau 14 comporte plusieurs arrivées 22, chaque arrivée 22 comportant un premier 24A, 24B, un deuxième 26A, 26B, et un troisième 28A, 28B conducteurs d'arrivée. Chaque premier, deuxième, troisième conducteur d'arrivée 24A, 24B, 26A, 26B, 28A, 28B est relié au réseau électrique par l'intermédiaire d'un disjoncteur d'arrivée 32 respectif. Le courant triphasé circulant dans les conducteurs d'arrivée 24A, 24B, 26A, 26B, 28A, 28B correspondants présente la première tension triphasée.

Le deuxième tableau 16 comprend un premier 34, un deuxième 36, un troisième 38 et un quatrième 39 conducteurs primaires et une pluralité N de départs 40A, 40B, ...40N, à savoir un premier départ 40A, un deuxième départ 40B, ..., un Nième départ 40N, chaque départ 40A, 40B, ..., 40N étant propre à délivrer une tension triphasée.

Chaque départ 40A, 40B,... , 40N est un départ basse tension, c'est-à-dire de tension inférieure à 1 000 V. La deuxième tension triphasée est alors une basse tension. En variante, chaque départ 40A, 40B, ..., 40N est un départ moyenne tension, c'est-à-dire de tension est supérieure à 1 000 V et inférieure à 50 000 V.

Le premier départ 40A comporte un premier 42A, un deuxième 44A, un troisième 46A et un quatrième 48A conducteurs secondaires et trois disjoncteurs de départ 50. Les premier, deuxième et troisième conducteurs secondaires 42A, 42B, 42C sont respectivement reliés aux premier, deuxième et troisième conducteurs primaires 34, 36, 38 par l'intermédiaire d'un disjoncteur de départ 50 correspondant. Le quatrième conducteur secondaire 48A est directement connecté au quatrième conducteur primaire 39.

Les conducteurs primaires de départ 34, 36, 38 et les conducteurs secondaires de départ 42A, 44A, 46A correspondants présentent sensiblement la même tension, à savoir respectivement une première tension U1, une deuxième tension U2 et une troisième tension U3 correspondant aux trois phases de la deuxième tension triphasée.

Les autres départs 40B, ...40N sont identiques au premier départ 40A décrit précédemment, et comportent les mêmes éléments en remplaçant à chaque fois la lettre A par la lettre B, ..., N correspondante concernant les références des éléments.

Le transformateur électrique 18 est propre à transformer le courant issu du réseau électrique présentant la première tension alternative en le courant délivré au deuxième tableau 16 et présentant la deuxième tension alternative. Le transformateur électrique 18 comporte un enroulement primaire 52 connecté au premier tableau 14 et un enroulement secondaire 54 connecté au deuxième tableau 16.

Le système de surveillance 20 est configuré pour surveiller le deuxième tableau 16, notamment pour calculer l'énergie électrique du courant circulant dans le ou chaque conducteur secondaire de départ 42A, 44A, 46A, 42B, 44B, 46B, ..., 42N, 44N, 46N.

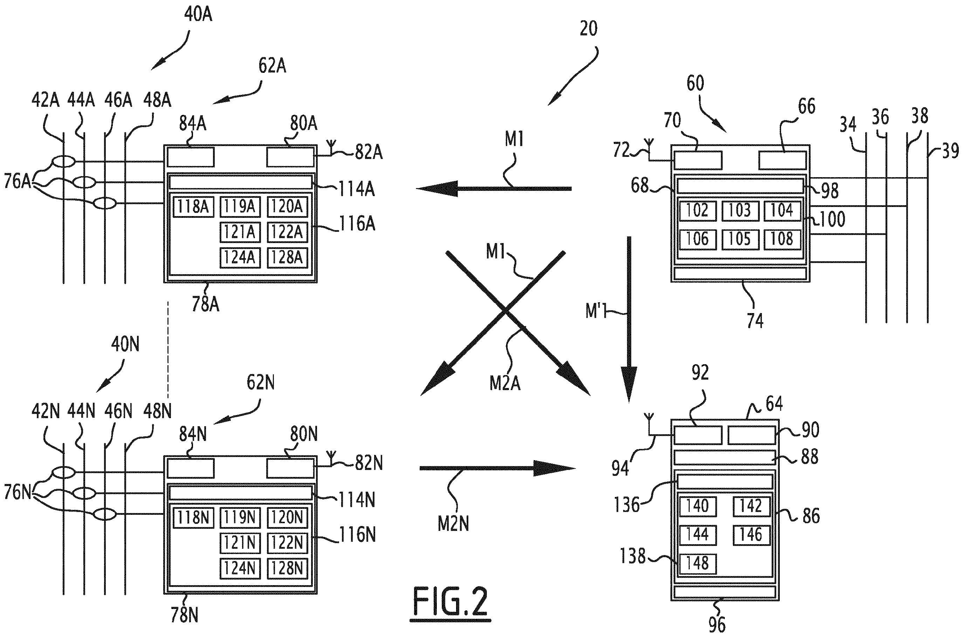

Le système de surveillance 20, visible sur la figure 2, comprend un premier dispositif électronique 60 de surveillance de la tension U1, U2, U3 de chaque conducteur électrique primaire de départ 34, 36, 38, une pluralité N de deuxièmes dispositifs électroniques 62A, 62B, ..., 62N de surveillance de l'intensité I1A, ..., I3N du courant alternatif circulant dans chaque conducteur électrique secondaire 42A, ..., 46N, et un dispositif électronique de centralisation 64.

Le premier dispositif 60 comporte un module 66 de mesure de la tension du courant circulant dans le conducteur primaire 34, 36, 38 correspondant, et une unité 68 de traitement d'informations. Le premier dispositif 60 comporte également un émetteur-récepteur radioélectrique 70, une antenne radioélectrique 72, et un module 74 d'alimentation électrique du module de mesure, de l'unité de traitement d'informations et de l'émetteur-récepteur radioélectrique.

Le deuxième dispositif avec la référence 62A comporte, pour chacun des premier 42A, deuxième 44A et troisième 46A conducteurs secondaires, un capteur 76A de l'intensité du courant circulant dans le conducteur secondaire 42A, 44A, 46A correspondant. Le deuxième dispositif 62A comporte une unité 78A de traitement d'informations, un émetteur-récepteur radioélectrique 80A, et une antenne radioélectrique 82A. Le deuxième dispositif 62A comporte également un module 84A d'alimentation électrique de l'unité de traitement d'informations et de l'émetteur-récepteur radioélectrique. Le deuxième dispositif 62A est identifié par un numéro unique, également appelé identifiant.

Les autres deuxièmes dispositifs 62B, ..., 62N sont identiques au deuxième dispositif 62A décrit précédemment, et comportent les mêmes éléments en remplaçant à chaque fois la lettre A par la lettre B, ..., N correspondante concernant les références des éléments. Chacun des autres deuxièmes dispositifs 62B, ..., 62N présente également un identifiant unique.

Le dispositif de centralisation 64 comporte une unité 86 de traitement d'informations, une base de données 88 et une interface homme-machine 90. Le dispositif de centralisation 64 comporte un émetteur-récepteur radioélectrique 92, une antenne radioélectrique 94 et un module 96 d'alimentation électrique de l'unité de traitement d'informations, de la base de données, de l'interface homme-machine et de l'émetteur-récepteur radioélectrique.

Le module de mesure 66 est propre à mesurer la première tension U1 de la phase circulant à travers le premier conducteur primaire 34, la deuxième tension U2 de la phase circulant à travers le deuxième conducteur primaire 36, et la troisième tension U3 de la phase circulant à travers le troisième conducteur primaire 38. Le module de mesure 66 est également propre à mesurer la fréquence F de la tension triphasée circulant à travers les conducteurs primaires 34, 36, 38.

L'unité de traitement d'informations 68 comporte un processeur 98 et une mémoire 100 apte à stocker un premier logiciel 102 d'acquisition de valeurs des tensions U1, U2, U3 mesurées par le module de mesure 66 et un premier logiciel 103 d'échantillonnage, avec une période d'échantillonnage $P_{ech}$, de la valeur de la tension mesurée U1, U2, U3. Les échantillons de la tension mesurée U1, U2, U3 sont notés respectivement $U1_{k,m}$, $U2_{k,m}$, $U3_{k,m}$ où k est un indice d'une fenêtre d'échantillonnage de durée prédéterminée, associée à l'échantillonnage, et m est un indice d'échantillon variant entre 1 et $N_{ech}$, $N_{ech}$ étant un nombre entier représentant le nombre d'échantillons de tensions dans la fenêtre d'échantillonnage. $N_{ech}$ est par exemple égal à 36.

La fenêtre d'échantillonnage est, par exemple, choisie égale à la période de tension $P_{tension}$, c'est-à-dire égale à l'inverse de la fréquence de tension F mesurée par le module de mesure 66. La fenêtre d'échantillonnage est recalculée à chaque période d'émission $P_{émission}$ en fonction de la valeur de la fréquence de tension F mesurée par le module de mesure 66 et acquise par le premier logiciel d'acquisition 102, lors de l'avant-dernière période d'émission $P_{émission}$. Le fait de calculer la fenêtre d'échantillonnage pour le premier dispositif 60 avec la valeur de la fréquence de tension F mesurée lors de l'avant-dernière période d'émission permet d'utiliser une même valeur de fréquence de tension F pour calculer la fenêtre d'échantillonnage à la fois pour le premier dispositif 60 et chacun des deuxièmes dispositifs 62A, ..., 62N.

La mémoire 100 est apte à stocker un premier logiciel 104 de détermination d'une pluralité de coefficients d'une transformée des échantillons $U1_{k,m}$, $U2_{k,m}$, $U3_{k,m}$ de chaque tension mesurée, jusqu'à un rang J de valeur supérieure ou égale à 1, de préférence supérieure ou égale à 5, de préférence encore égale à 15. Par convention, le rang égal à 1 correspond au fondamental de la transformée.

D'après le théorème de Shannon, la valeur de J doit être inférieure ou égale à $(N_{ech}/2)-1$. La valeur de J sera de préférence choisie égale à $(N_{ech}/2)-3$. Dans l'exemple de réalisation décrit, $N_{ech}$ est égal à 36, et valeur de J est alors égale à 15 avec la formule précitée.

La mémoire 100 est apte à stocker un premier logiciel 105 d'émission d'un premier message principal M1 à destination de chaque deuxième dispositif 62A, ..., 62N et d'un premier message additionnel M'1 à destination du dispositif de centralisation 64. Les instants d'émission de deux messages principaux M1 successifs, et de deux messages additionnels M'1 successifs, sont séparés par une période d'émission $P_{émission}$. Chaque période d'émission $P_{émission}$ présente de préférence une valeur prédéterminée, par exemple égale à une seconde.

Chaque période d'émission $P_{émission}$ correspond à un multiple de périodes de tension $P_{tension}$, la période de tension $P_{tension}$ étant égale à l'inverse de la fréquence F de la tension alternative U1, U2, U3. Le multiple est de préférence un nombre entier de valeur supérieure ou égale à 2, et la période d'émission $P_{émission}$ correspond alors à un multiple entier de périodes de tension $P_{tension}$.

En variante, le multiple est un nombre réel de valeur strictement supérieure à 1. Selon cette variante, un lissage de la valeur des échantillons de l'intensité mesuré sera alors effectué pour prendre en compte cette valeur non entière du multiple.

La mémoire 100 est apte à stocker un premier logiciel de calcul 106 configuré pour calculer au moins un paramètre de surveillance de la tension U1, U2, U3 en fonction d'au moins une valeur mesurée de ladite tension U1, U2, U3, de préférence en fonction de certaines des valeurs mesurées de ladite tension U1, U2, U3 au cours d'une période d'émission $P_{émission}$ donnée. Chaque paramètre de surveillance est choisi parmi une phase angulaire de la tension U1, U2, U3 et un module de la tension U1, U2, U3. Le premier logiciel de calcul 106 est de préférence configuré pour calculer à la fois la phase angulaire de la tension U1, U2, U3 et le module de la tension U1, U2, U3.

Dans la suite de la description, chaque période de tension est également référencée à l'aide de l'indice k, étant donné que la fenêtre d'échantillonnage est de préférence égale à la période de tension.

La mémoire 100 est apte à stocker un logiciel 108 de distribution d'un unique jeton aux deuxièmes dispositifs 62A, ..., 62N de manière successive.

Lorsqu'ils sont exécutés par le processeur 98, le premier logiciel d'acquisition 102, le premier logiciel d'échantillonnage 103, le premier logiciel de détermination 104, le premier logiciel d'émission 105, le premier logiciel de calcul 106, et respectivement le logiciel de distribution du jeton distribué 108 forment un premier module d'acquisition de valeurs des tensions U1, U2, U3 mesurées, un premier module d'échantillonnage des valeurs des tensions U1, U2, U3 mesurées, un premier module de détermination des coefficients de transformée des échantillons, un premier module d'émission des premiers messages M1, M'1, un premier module de calcul d'au moins un paramètre de surveillance de la tension, et respectivement un module de distribution du jeton distribué.

En variante, le premier module d'acquisition 102, le premier module d'échantillonnage 103, le premier module de détermination 104, le premier module d'émission 105, le premier module de calcul 106, et le module de distribution du jeton distribué 108 sont réalisés sous forme de composants logiques programmables ou encore sous forme de circuits intégrés dédiés.

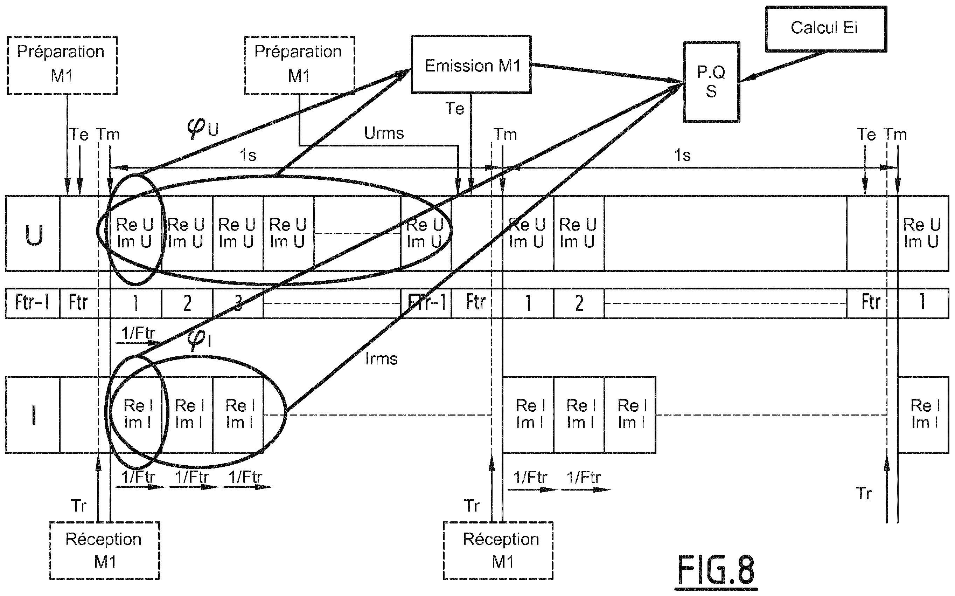

La transformée est, par exemple, une transformée de Fourier, et le premier logiciel de détermination 104 est propre à calculer les coefficients réel $ReU_{i,j,k}$ et imaginaire $ImU_{i,j,k}$ de la décomposition en série de Fourier des échantillons $Ui_{k,m}$ de chaque tension mesuré Ui, où i est un indice de la phase correspondante, par exemple respectivement égal à 1, 2 et 3, j est un rang de la décomposition en série de Fourier, avec j compris entre 1 et J, J étant égal au nombre de rangs de ladite décomposition, k est l'indice de la période de tension $P_{tension}$ correspondante, avec k compris entre 1 et K, K étant égal au nombre de périodes de tension $P_{tension}$ pendant une période d'émission $P_{émission}$. Dans l'exemple de la figure 8, K est noté Ftr, la valeur K dépendant de la fréquence F de la tension. Dans l'exemple de réalisation, la période d'émission $P_{émission}$ est égale à une seconde et la période de tension $P_{tension}$ est sensiblement égale à 20 ms, de sorte que K est sensiblement égal à 50.

En variante, la transformée est une transformée de Laplace.

L'émetteur-récepteur radioélectrique 70 est conforme au protocole de communication ZigBee basé sur la norme IEEE-802.15.4. En variante, l'émetteur-récepteur radioélectrique 70 est conforme à la norme IEEE-802.15.1, ou à la norme IEEE-802.15.2, ou encore à la norme IEEE-802-11 ou encore tout autre protocole radio propriétaire.

L'antenne radioélectrique 72 est adaptée pour émettre des signaux radioélectriques à destination des antennes 82A, ..., 82N des deuxièmes dispositifs et de l'antenne 94 du dispositif de centralisation, et également pour recevoir des signaux radioélectriques desdites antennes 82A, ..., 82N, 94. Autrement dit, le premier dispositif 60 est relié à chacun des deuxièmes dispositifs 62A, ..., 62N et au dispositif de centralisation 64 par une liaison radioélectrique correspondante.

Le module d'alimentation 74 est propre à alimenter électriquement le module de mesure 66, l'unité de traitement d'informations 68 et l'émetteur-récepteur radioélectrique 70 à partir de la tension triphasée circulant à travers les conducteurs primaires 34, 36, 38.

Chaque capteur de l'intensité 76A du deuxième dispositif 62A est propre à mesurer une intensité respective parmi une première intensité I1A circulant dans le premier conducteur secondaire de départ 42A, une deuxième intensité I2A circulant dans le deuxième conducteur secondaire de départ 44A et une troisième intensité I3A circulant dans le troisième conducteur secondaire de départ 46A.

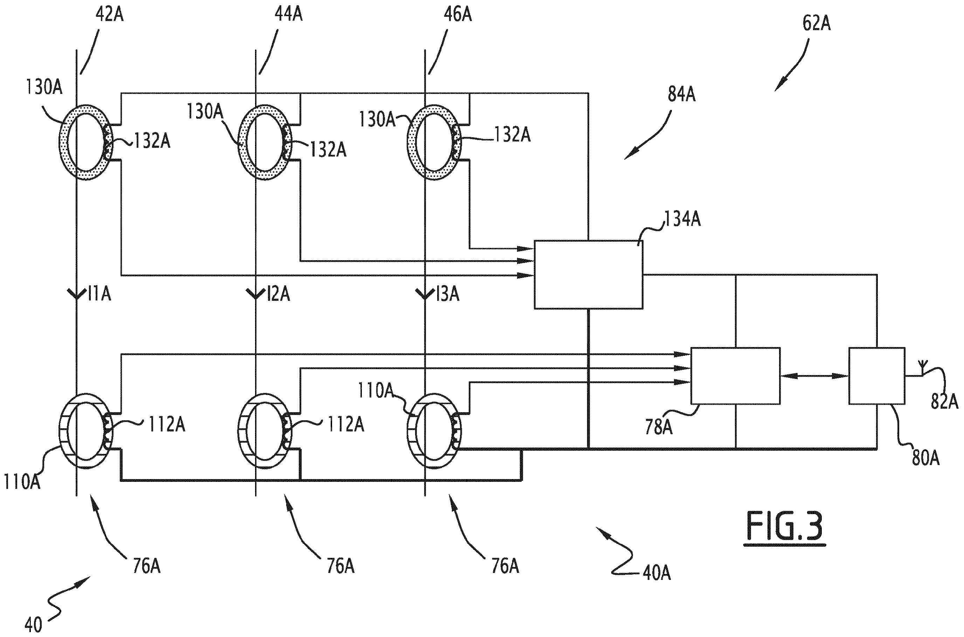

Chaque capteur de l'intensité 76A, également appelé capteur de courant, comporte un premier tore 110A disposé autour du conducteur secondaire de départ 42A, 44A, 46A correspondant et un premier enroulement 112A agencé autour du premier tore, comme représenté sur la figure 3. La circulation du courant à travers le conducteur secondaire de départ correspondant est propre à engendrer un courant induit proportionnel à l'intensité du courant dans le premier enroulement 112A. Le premier tore 110A est un tore de Rogowski. Le premier tore 110A est de préférence un tore ouvrant afin de faciliter son agencement autour des conducteurs correspondants.

L'unité de traitement d'informations 78A, visible sur la figure 2, comporte un processeur de données 114A, et une mémoire 116A associée au processeur de données. La mémoire 116A est propre à stocker un deuxième logiciel 118A d'acquisition de valeurs des intensités respectives mesurées par chaque capteur de courant 76A, et un deuxième logiciel 119A d'échantillonnage, avec une période d'échantillonnage $P_{ech}$, de la valeur des première, deuxième et troisième intensités I1A, I2A, I3A mesurées, et un logiciel 120A de réception du premier message principal M1.

Les échantillons des première, deuxième et troisième intensités I1A, I2A, I3A mesurées sont notés respectivement $I1A_{k,m}$, $I2A_{k,m}$, $I3A_{k,m}$ où k est l'indice de la fenêtre d'échantillonnage de durée prédéterminée, associée à l'échantillonnage, et m est l'indice d'échantillon variant entre 1 et $N_{ech}$, $N_{ech}$ étant le nombre entier représentant le nombre d'échantillons de tensions dans la fenêtre d'échantillonnage.

La fenêtre d'échantillonnage est, par exemple, choisie égale à la période de tension $P_{tension}$, c'est-à-dire égale à l'inverse de la fréquence de tension F, cette valeur de la fréquence étant contenue dans chaque premier message principal M1 reçu. La fenêtre d'échantillonnage est recalculée à chaque période d'émission $P_{émission}$ en fonction de la valeur de la fréquence de tension F contenue dans le premier message principal M1 reçu en dernier, lors de la période précédente d'émission $P_{émission}$, c'est-à-dire la valeur de la fréquence de tension F mesurée lors de l'avant-dernière période d'émission par le module de mesure 60 du premier dispositif.

La mémoire 116A est apte à stocker un deuxième logiciel 121A de détermination d'une pluralité de coefficients d'une transformée des échantillons $I1A_{k,m}$, $I2A_{k,m}$, $I3A_{k,m}$ jusqu'au rang J . La transformée est, par exemple, une transformée de Fourier, et le deuxième logiciel de détermination 121A est propre à calculer les coefficients réel $Re/_{iA,j,k}$ et imaginaire $Im/_{iA,j,k}$ de la décomposition en série de Fourier des échantillons $IiA_{k,m}$ de chaque intensité mesurée IiA, où i est l'indice de la phase correspondante, j est le rang de la décomposition en série de Fourier, avec j compris entre 1 et J, k est l'indice de la période de tension $P_{tension}$ correspondante, avec k compris entre 1 et K.

En variante, la transformée est une transformée de Laplace.

La mémoire 116A est apte à stocker un logiciel 122A de synchronisation de l'échantillonnage des intensités I1A, I2A, I3A mesurées par rapport à l'échantillonnage de la tension mesuré U1, U2, U3. Par convention, la période de tension d'indice k égal à 1 correspond à la période temporelle au cours de laquelle le premier message M1 est émis par le premier dispositif 60 et respectivement reçu par chaque deuxième dispositif 62A, ..., 62N, et la période de tension d'indice k égal à 2 correspond à la période au début de laquelle la synchronisation des échantillonnages de tension et d'intensités est effectuée.

La mémoire 116A est apte à stocker un deuxième logiciel de calcul 124A configuré pour calculer au moins un paramètre de surveillance des première, deuxième et troisième intensités I1A, I2A, I3A en fonction d'au moins une valeur mesurée desdites intensités I1A, I2A, I3A, de préférence en fonction de certaines des valeurs mesurées desdites intensités I1A, I2A, I3A au cours d'une période d'émission $P_{émission}$ donnée. Chaque paramètre de surveillance est choisi parmi une phase angulaire des première, deuxième et troisième intensités I1A, I2A, I3A et un module des première, deuxième et troisième intensités I1A, I2A, I3A. Le deuxième logiciel de calcul 124A est de préférence configuré pour calculer à la fois la phase angulaire desdites intensités I1A, I2A, I3A et le module desdites intensités I1A, I2A, I3A.

La mémoire 116A est apte à stocker un deuxième logiciel 128A d'émission d'un deuxième message M2A à destination du dispositif de centralisation 64.

Lorsqu'ils sont exécutés par le processeur 114A, le deuxième logiciel d'acquisition 118A, le deuxième logiciel d'échantillonnage 119A, le logiciel de réception 120A, le deuxième logiciel de détermination 121A, le logiciel de synchronisation 122A, le deuxième logiciel de calcul 124A, et respectivement le deuxième logiciel d'émission 128A forment un deuxième module d'acquisition de valeurs des intensités mesurées, un deuxième module d'échantillonnage des valeurs des intensités mesurées, un module de réception du premier message principal M1, un deuxième module de détermination des coefficients de transformée des échantillons, un module de synchronisation de l'échantillonnage des intensités I1A, I2A, I3A mesurées par rapport à l'échantillonnage de la tension mesurée U1, U2, U3, un deuxième module de calcul d'au moins un paramètre de surveillance de l'intensité, et respectivement un deuxième module d'émission du deuxième message M2A.

En variante, le deuxième module d'acquisition 118A, le deuxième module d'échantillonnage 119A, le module de réception 120A, le deuxième module de détermination 121A, le module de synchronisation 120A, le deuxième module de calcul 124A et le deuxième module d'émission 128A sont réalisés sous forme de composants logiques programmables ou encore sous forme de circuits intégrés dédiés.

L'émetteur-récepteur radioélectrique 80A est du même type que l'émetteur-récepteur radioélectrique 70.

L'antenne radioélectrique 82A, du même type que l'antenne radioélectrique 72, est adaptée pour recevoir des signaux radioélectriques de l'antenne 72 du premier dispositif et de l'antenne 94 du dispositif de centralisation et également pour émettre des signaux radioélectriques aux antennes 72, 94.

Le module d'alimentation 84A, visible sur la figure 3, est propre à alimenter l'unité de traitement d'informations 78A et l'émetteur-récepteur radioélectrique 80A. Le module d'alimentation 84A comporte, pour chacun des premier 42A, deuxième 44A et troisième 46A conducteurs secondaires, un deuxième tore 130A disposé autour du conducteur secondaire 42A, 44A, 46A correspondant et un deuxième enroulement 132A agencé autour du deuxième tore. La circulation du courant dans le conducteur secondaire 42A, 44A, 46A correspondant est propre à engendrer un courant induit dans le deuxième enroulement 132A.

Le module d'alimentation 84A comporte un convertisseur 134A connecté à chacun des deuxièmes enroulements 132A et propre à délivrer une tension prédéterminée à l'unité de traitement d'informations 78A et à l'émetteur-récepteur radioélectrique 80A. Chaque deuxième tore 130A est un tore en fer. Chaque deuxième tore 130A est de préférence un tore ouvrant afin de faciliter son agencement autour des conducteurs correspondants.

Autrement dit, le deuxième dispositif 62A est autoalimenté par l'intermédiaire du module d'alimentation 84A comportant les deuxièmes tores 130A adaptés pour récupérer l'énergie magnétique issue de la circulation du courant dans les conducteurs secondaires 42A, 44A, 46A correspondants.

Les éléments des autres deuxièmes dispositifs 62B, ..., 62N sont identiques aux éléments du premier deuxième dispositif 62A décrits précédemment, et comportent les mêmes sous-éléments en remplaçant à chaque fois la lettre A par la lettre B, ..., N correspondante concernant les références des sous-éléments.

L'unité de traitement d'informations 86 du dispositif de centralisation, visible sur la figure 2, comporte un processeur de données 136, et une mémoire 138 associée au processeur. La mémoire 138 est apte à stocker un logiciel 140 de réception du premier message additionnel M'1 et des deuxièmes messages M2A,..., M2N, un logiciel 142 d'enregistrement dans la base de données 88 des informations contenues dans les messages M'1, M2A,..., M2N reçus. La mémoire 138 est propre à stocker un logiciel 144 de traitement desdites informations reçues, un logiciel 146 d'affichage de données et un logiciel 148 de transmission de données à destination d'un serveur distant, non représenté. Le logiciel de traitement 144 est notamment configuré pour calculer l'énergie électrique $E_i$ du courant alternatif circulant dans chaque conducteur électrique secondaire 42A, ..., 46N à partir des paramètres de surveillance calculés par le premier dispositif de surveillance 60 et par chaque deuxième dispositif de surveillance 62A, ..., 62N, ces paramètres de surveillance calculés étant contenus dans les messages de données M'1, M2A, ..., M2N reçus.

Lorsqu'ils sont exécutés par le processeur 136, le logiciel de réception 140, le logiciel d'enregistrement 142, le logiciel de traitement 144, le logiciel d'affichage 146, et respectivement le logiciel de transmission 148 forment un module de réception du premier message additionnel M'1 et des deuxièmes messages M2A,..., M2N, un module d'enregistrement dans la base de données 88 des informations contenues dans les messages M'1, M2A,..., M2N reçus, un module de traitement desdites informations reçues, un module d'affichage de données et un module de transmission de données à destination d'un serveur distant.

En variante, le module de réception 140, le module d'enregistrement 142, le module de traitement 144, le module d'affichage 146, et le module de transmission 148 sont réalisés sous forme de composants logiques programmables ou encore sous forme de circuits intégrés dédiés.

L'interface homme-machine 90 comporte un écran d'affichage et un clavier de saisie, non représentés.

L'émetteur-récepteur radioélectrique 92 est du même type que les émetteurs-récepteurs radioélectriques 70, 80A, ..., 80N.

L'antenne radioélectrique 94, du même type que les antennes radioélectriques 72, 82A, ..., 82N, est propre à recevoir des signaux radioélectriques issus de l'antenne 72 du premier dispositif et des antennes 82A, ..., 82N des deuxièmes dispositifs et également à émettre des signaux radioélectriques à destination desdites antennes 72, 82A, ..., 82N.

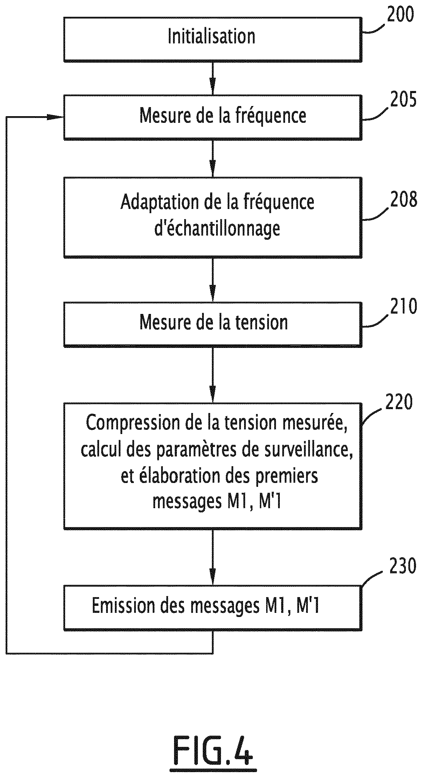

Le fonctionnement du système de surveillance 20 va désormais être expliqué à l'aide des figures 4, 5 et 6 représentant des organigrammes des étapes d'un procédé de surveillance mises en œuvre respectivement par le premier dispositif 60, par les deuxièmes dispositifs 62A, ..., 62N et par le dispositif de centralisation 64.

Comme représenté sur la figure 4, lors d'une première étape 200, le premier dispositif 60 s'initialise, puis mesure lors de l'étape suivante 205 la fréquence F de la tension triphasée circulant à travers les conducteurs primaires 34, 36, 38 par l'intermédiaire du module de mesure 60 et du premier logiciel d'acquisition 102. La fréquence F de la tension triphasée est, par exemple, sensiblement égale à 50 Hz.

Afin d'optimiser la précision de la mesure de l'énergie, la période $P_{tension}$ de la tension est mesurée régulièrement, de préférence à chaque période d'émission $P_{émission}$, afin de prendre en compte des variations dans le temps de celle-ci.

Lors de l'étape suivante 208, la fenêtre d'échantillonnage est calculée par le premier logiciel d'échantillonnage 103 en fonction de la valeur de la fréquence F de la tension triphasée. Autrement dit, la période d'échantillonnage $P_{ech}$ est calculée à partir de la valeur de la fréquence F, sachant que le produit de la période d'échantillonnage $P_{ech}$ et de la fréquence F est égal à une constante prédéterminée.

Plus précisément, la période d'échantillonnage $P_{ech}$ vérifie l'équation suivante :

$$P_{ech} \times F = \frac{1}{N_{ech}} \tag{1}$$

ou encore :

$$P_{ech} = \frac{P_{tension}}{N_{ech}} \tag{2}$$

Dans l'exemple de réalisation décrit, $N_{ech}$ est égal à 36, et la fenêtre d'échantillonnage comporte alors 36 échantillons de tension pour chaque période $P_{tension}$ de la tension. La période $P_{tension}$ de la tension triphasée est égale à la période du réseau, soit environ 20 ms en Europe et environ 16,66 ms aux Etats Unis. La période de tension $P_{tension}$ correspond à un multiple de la période d'échantillonnage $P_{ech}$, conformément à l'équation (2) ci-dessus.

Le premier dispositif 60 mesure ensuite, lors de l'étape 210, les première, deuxième et troisième tensions U1, U2, U3 à l'aide de son module de mesure 66 et de son premier logiciel d'acquisition 102. Le premier logiciel d'échantillonnage 103 échantillonne alors les valeurs mesurées des tensions U1, U2, U3 suivant la période d'échantillonnage $P_{ech}$, calculée lors de l'étape 208.

Lors de l'étape 220, le premier dispositif 60 compresse les valeurs mesurées des tensions U1, U2, U3 en déterminant des coefficients réel $ReU_{i,j,k}$, et imaginaire $ImU_{i,j,k}$ de la décomposition en série de Fourier des échantillons $Ui_{k,m}$ de chaque tension mesurée U1, U2, U3 à l'aide de son premier logiciel de détermination 104. Ceci permet de limiter la quantité de données transmises par l'intermédiaire des liaisons radioélectriques entre le premier dispositif 60 et le dispositif de centralisation 64.

Les coefficients $ReU_{i,j,k}$, $ImU_{i,j,k}$ de la décomposition en série de Fourier sont, par exemple, obtenus par des opérations de corrélation sur les échantillons des valeurs mesurées. Plus précisément, le coefficient réel du fondamental, noté $ReU_{i,1,k}$, est une corrélation, sur une durée égale à la période $P_{tension}$ de la tension triphasée, entre les échantillons $Ui_{k,m}$ du signal de tension Ui et un cosinus de fréquence égale à la fréquence F de la tension triphasée, où Ui représente la tension de la phase, i étant égal à 1, 2 ou 3. Le coefficient imaginaire du fondamental, noté $ImU_{i,1,k}$, est une corrélation, sur une durée égale à la période $P_{tension}$, entre les échantillons $Ui_{k,m}$ du signal de tension Ui et un sinus de fréquence égale à la fréquence F.

Le coefficient réel de l'harmonique de rang j, noté $ReU_{i,j,k}$, j étant compris entre 2 et J, est la corrélation, sur une durée égale à la période $P_{tension}$, entre les échantillons $Ui_{k,m}$ du signal de tension Ui et un cosinus de fréquence égale à j fois la fréquence F. Le coefficient imaginaire de l'harmonique de rang j, noté $ImU_{i,j,k}$, est la corrélation, sur une durée égale à la période $P_{tension}$, entre les échantillons $Ui_{k,m}$ du signal de tension Ui et un sinus de fréquence égale à j fois la fréquence F.

Autrement dit, les coefficients $ReU_{i,j,k}$ et $ImU_{i,j,k}$ vérifient les équations suivantes, j étant compris entre 1 et J :

$$ReU_{i,j,k} = \sum_{m=1}^{N_{ech}} Ui_{k,m} \times \cos(2 \times \Pi \times F_{tension} \times j \times m \times T) \tag{3}$$

$$ImU_{i,j,k} = \sum_{m=1}^{N_{ech}} Ui_{k,m} \times \sin(2 \times \Pi \times F_{tension} \times j \times m \times T) \tag{4}$$

où T représente la période d'échantillonnage, également notée $P_{ech}$.

En variante, les coefficients $ReU_{i,j,k}$ et $ImU_{i,j,k}$ sont obtenus par une transformée de Fourier rapide, également appelée FFT (de l'anglais *Fast Fourier Transform*).

Le premier logiciel de détermination 104 calcule ainsi les coefficients complexes $\mathrm{Re}U_{i,j,k}$ et $\mathrm{Im}U_{i,j,k}$ des décompositions en série de Fourier des trois tensions U1, U2, U3 pour le fondamental et les harmoniques 2 à J.

Le premier logiciel de calcul 106 calcule alors les paramètres de surveillance, par exemple la phase angulaire de la tension à l'aide de l'équation suivante :

$$\varphi_{i,j,k}(U) = \arctan\left(\frac{\mathrm{Im}\,U_{i,j,k}}{\mathrm{Re}\,U_{i,j,k}}\right) \tag{5}$$

où $\varphi_{i,j,k}(U)$ est la phase angulaire de la tension pour la phase d'indice i, l'harmonique de rang j, la période de tension $P_{tension}$ d'indice k,

$\mathrm{Re}U_{i,j,k}$, $\mathrm{Im}U_{i,j,k}$ représentent des coefficients réel et imaginaire d'une décomposition en série de Fourier de la tension pour la phase d'indice i, l'harmonique de rang j, et la période de tension $P_{tension}$ d'indice k.

La phase angulaire $\varphi_{i,j,k}(U)$ de la tension est de préférence calculée seulement pour la première période de tension $P_{tension}$ d'indice 1.

La phase angulaire $\varphi_{i,j,k}(U)$ de la tension est de préférence calculée seulement pour les harmoniques de rang j respectivement égal à 1, 3 et 5.

En complément, le premier logiciel de calcul 106 calcule le module de la tension à l'aide de l'équation suivante :

$$\left\|U_{i,j,k}\right\| = \sqrt{\frac{\left(\mathrm{Re}\,U_{i,j,k}\right)^2 + \left(\mathrm{Im}\,U_{i,j,k}\right)^2}{2}} \tag{6}$$

où $\|U_{i,j,k}\|$ est le module, au sens mathématique, de la tension pour la phase d'indice i, l'harmonique de rang j, la période de tension $P_{tension}$ d'indice k,

$\mathrm{Re}U_{i,j,k}$, $\mathrm{Im}U_{i,j,k}$ représentent des coefficients réel et imaginaire d'une décomposition en série de Fourier de la tension pour la phase d'indice i, l'harmonique de rang j, et la période de tension $P_{tension}$ d'indice k.

Le module $\|U_{i,j,k}\|$ de la tension est de préférence calculé pour chacune des périodes de tension $P_{tension}$ d'indice k compris entre 1 et $K_{max,U}$, $K_{max,U}$ étant par exemple égal à K-1.

Le module $\|U_{i,j,k}\|$ de la tension est de préférence calculé pour les harmoniques de rang j respectivement égal à chacune des valeurs impaires comprises entre 1 et J.

Enfin, lors de l'étape 230, le premier dispositif 60 émet, à l'aide de son logiciel d'émission 105, le premier message principal M1 à destination de chacun des deuxièmes dispositifs 62A, ..., 62N et le premier message additionnel M'1 à destination du dispositif de centralisation 64.

Le premier dispositif 60 lance en outre, lors de cette étape 230, une première temporisation égale à une durée de référence Df, à compter de l'instant de début d'émission du premier message M1, également appelé top d'émission Te du premier message M1. Lorsque cette première temporisation sera écoulée, le premier dispositif 60 débutera alors l'échantillonnage des valeurs mesurées des trois tensions U1, U2, U3, c'est-à-dire à un instant de début d'échantillonnage Tm égal à l'instant de début d'émission Te plus la durée de référence Df. L'échantillonnage, par le deuxième dispositif 62A, des valeurs mesurées des trois intensités I1A, I2A, I3A commencera également à cet instant de début d'échantillonnage Tm, comme cela sera décrit plus en détail par la suite en regard de l'étape de synchronisation 320.

La durée de référence Df a une valeur prédéterminée, par exemple sensiblement égale à 6 ms. La valeur de la durée de référence Df est connue à la fois du premier dispositif 60 et du deuxième dispositif 62A, et est choisie supérieure à la durée nécessaire à l'émission et à la réception du premier message M1. Dans l'exemple de réalisation décrit, la valeur de la durée de référence Df est stockée, préalablement à l'étape initiale 200, dans la mémoire 100 du premier dispositif et dans la mémoire 116A du deuxième dispositif 62A.

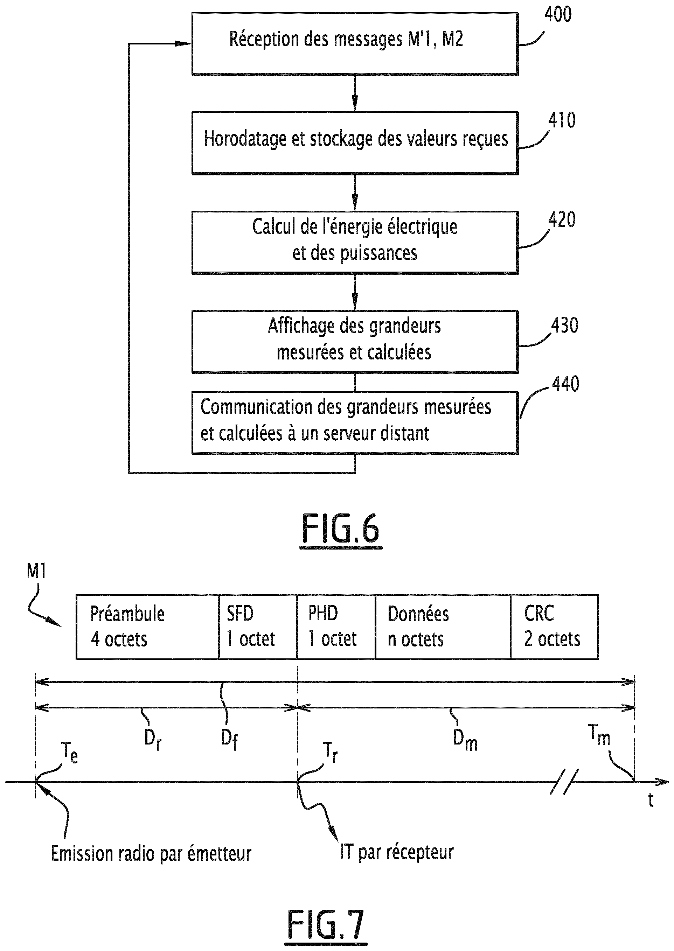

Le premier message principal M1 et le premier message additionnel M'1 comprennent chacun un champ d'entête, également appelé préambule, un champ SFD (de l'anglais Start of Frame Delimiter), un champ PHR (de l'anglais Physical Header), un champ de données et un champ CRC (de l'anglais Cyclic Redundancy Check). Le préambule présente une taille de 4 octets, les champs SFD et PHR présentent chacun une taille d'un octet, le champ de données est de taille variable, notée n octets, et le champ CRC a une taille de 2 octets. Dans l'exemple de réalisation de la figure 7, le premier message M1 est constitué du champ d'en-tête, du champ SFD, du champ PHR, du champ de données et du champ CRC.

Le champ de données du premier message principal M1 contient la valeur de la fréquence F mesurée lors de l'étape 205, l'identifiant du deuxième dispositif qui sera autorisé à émettre son deuxième message à destination du dispositif de centralisation 64 après la réception du premier message M1, ainsi que la valeur de la durée de référence Df en cas de modification de cette dernière. L'identifiant du deuxième dispositif autorisé à émettre ses informations de mesure est déterminé à l'aide du logiciel de distribution du jeton unique 108, l'identifiant du dispositif contenu dans le premier message principal M1 permettant de désigner le deuxième dispositif à qui l'unique jeton a été attribué.

Le champ de données du premier message additionnel M'1 contient notamment les paramètres de surveillance $\varphi_{i,j,k}(U)$, $\|U_{i,j,k}\|$ déterminés précédemment lors de l'étape 220.

Après émission des premiers messages M1, M'1, le premier dispositif 60 retourne à l'étape 205 afin de mesurer à nouveau la fréquence F, puis la tension U1, U2, U3 des phases de la tension triphasée circulant dans les conducteurs primaires 34, 36, 38.

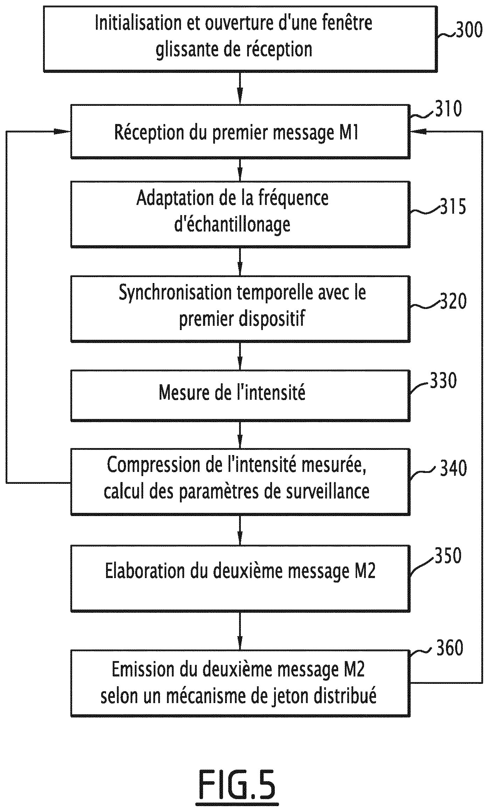

Les étapes, visibles sur la figure 5, du procédé de calcul mises en œuvre par les deuxièmes dispositifs 62A, ..., 62N vont être à présent décrites pour le deuxième dispositif avec la référence 62A.

Lors de l'étape 300, le deuxième dispositif 62A s'initialise et ouvre une fenêtre glissante de réception du premier message M1 à l'aide de son logiciel de réception 120A. La fenêtre de réception est une fenêtre présentant une durée de quelques dizaines de millisecondes que le deuxième dispositif 62A fait glisser dans le temps.

Lors de la réception du premier message M1 au cours de l'étape 310, le deuxième dispositif 62A détecte l'instant Tr de réception du champ SFD, la réception du champ SFD entrainant le déclenchement d'une interruption par le récepteur radioélectrique du deuxième dispositif 62A, comme représenté sur la figure 7.

Lors de l'étape suivante 315, la fenêtre d'échantillonnage est calculée par le deuxième logiciel d'échantillonnage 119A en fonction de la valeur de la fréquence F contenue dans le premier message M1 reçu. Cette étape est analogue à l'étape 208 décrite précédemment, la période d'échantillonnage $P_{ech}$ vérifiant les équations (1) et (2) précitées.

La période de tension $P_{tension}$ est ainsi recalculée, par le deuxième logiciel d'échantillonnage 119A, à chaque réception de premier message M1 à l'aide de la valeur de la fréquence de tension F contenue dans le premier message M1.

La fenêtre d'échantillonnage est alors calculée en fonction de la valeur de la fréquence de tension F mesurée lors de l'avant-dernière période d'émission $P_{émission}$ par le module de mesure 60 du premier dispositif. Afin d'utiliser une même fenêtre d'échantillonnage pour l'échantillonnage de l'intensité, d'une part, et de la tension, d'autre part, la valeur de la fréquence F, prise en compte par le premier dispositif 60 lors de l'étape 208, est de préférence l'avant-dernière valeur mesurée par le module de mesure 60.

Le deuxième dispositif 62A passe ensuite à l'étape 320 de synchronisation temporelle avec le premier dispositif 60. La détection de l'instant de réception Tr permet de calculer, à l'aide du logiciel de synchronisation 122A, l'instant Tm de début de l'échantillonnage des valeurs mesurées des trois intensités I1A, I2A, I3A. L'instant de début de l'échantillonnage Tm est en effet égal à l'instant de réception Tr plus une durée de synchronisation Dm, la durée de synchronisation Dm étant égale à la durée de référence Df moins une durée de transmission radio Dr, comme représenté sur la figure 7. La durée de transmission radio Dr est une valeur dépendant de l'émetteur-récepteur radioélectrique 70 et de l'émetteur-récepteur radioélectrique 80A. La durée de transmission radio Dr correspond à la période temporelle entre l'instant de début d'émission Te et l'instant de réception Tr.

La durée de transmission radio Dr est par exemple sensiblement égale à 0,6 ms, et est connue du deuxième dispositif 62A. Dans l'exemple de réalisation décrit, la valeur de la durée de transmission radio Dr est stockée, préalablement à l'étape 300, dans la mémoire 116A du deuxième dispositif 62A.

Le deuxième dispositif 62A lance alors, à partir de l'instant de réception Tr et à l'aide du logiciel de synchronisation 122A, une deuxième temporisation égale à la durée de synchronisation Dm, la valeur de la durée de synchronisation Dm étant calculée par soustraction de la valeur de la durée de transmission radio Dr à la valeur de la durée de référence Df, la valeur de la durée de transmission radio Dr et la valeur de la durée de référence Df étant stockées dans la mémoire 116A comme décrit précédemment.

Le premier dispositif 60 avait par ailleurs lancé, lors de l'étape 230, la première temporisation égale à la durée de référence Df, de sorte que le premier dispositif 60 et le deuxième dispositif 62A commenceront simultanément l'échantillonnage des valeurs de tension mesurées, et respectivement des valeurs d'intensité mesurées, lorsque les première et deuxième temporisations lancées aux étapes 230 et 320 seront écoulées, c'est-à-dire à l'instant de début d'échantillonnage Tm.

Par convention, la période de tension correspondant à l'émission du premier message M1 est la période d'indice k égal à 1. Lorsque le premier message M1 a également été reçu au cours de la période de tension d'indice k égal à 1, l'instant de début d'échantillonnage suite à la synchronisation correspond alors au début de la période de tension d'indice k égal à 2.

Lors de l'étape 320, le logiciel de synchronisation 122A initialise, à la date de réception du premier message M1, un compteur destiné à s'incrémenter jusqu'à une valeur correspondant à la période d'émission du premier message $P_{émission}$. Le deuxième dispositif 62A retourne alors automatiquement à l'étape de réception 310 environ une milliseconde avant la réception attendue du prochain premier message M1.

Si le premier message M1 n'est pas détecté par le deuxième dispositif 62A, la fenêtre de réception est refermée et aucune synchronisation n'est effectuée. Le compteur est alors incrémenté pour une nouvelle tentative de synchronisation sur le message M1 probable suivant.

Le deuxième dispositif 62A mesure alors, lors de l'étape 330 et par l'intermédiaire de ses capteurs de courant 76A et de son deuxième logiciel d'acquisition 118A, chacune des première, deuxième et troisième intensités I1A, I2A, I3A.

Le deuxième logiciel d'échantillonnage 119A échantillonne ensuite les valeurs mesurées des trois intensités I1A, I2A, I3A, l'instant de début de l'échantillonnage Tm ayant été calculé lors de l'étape 320 précédente afin d'assurer la synchronisation temporelle du capteur de l'intensité 76A par rapport à l'organe de mesure de la tension 66.

Le deuxième logiciel de détermination 121A compresse ensuite les valeurs mesurées des intensités I1A, I2A, I3A lors de l'étape 340. Le deuxième logiciel de détermination 121A calcule, par exemple, les coefficients réel $ReI_{iA,j,k}$, et imaginaire $ImI_{iA,j,k}$ de la décomposition en série de Fourier des échantillons $IiA_{k,m}$ de chaque intensité mesurée I1A, I2A, I3A des trois phases de manière analogue au calcul, décrit pour l'étape 220, des coefficients complexes $ReU_{i,j,k}$, $ImU_{i,j,k}$ de la décomposition en série de Fourier des tensions.

Le coefficient réel du fondamental, également noté $ReI_{iA,1,k}$, est ainsi une corrélation, sur une durée égale à la période $P_{tension}$ de la tension triphasée, entre les échantillons du signal de l'intensité IiA et un cosinus de fréquence égale à la fréquence F de la tension triphasée, où IiA représente l'intensité de la phase numéro i, i étant égal à 1, 2 ou 3. Le coefficient imaginaire du fondamental, également noté $ImI_{iA,1,k}$, est une corrélation, sur une durée égale à la période $P_{tension}$, entre les échantillons du signal de l'intensité IiA et un sinus de fréquence égale à la fréquence F.

Le coefficient réel de l'harmonique de rang j, noté $ReI_{iA,j,k}$, j étant compris entre 2 et J, est la corrélation, sur une durée égale à la période $P_{tension}$, entre les échantillons du signal de l'intensité IiA et un cosinus de fréquence égale à j fois la fréquence F. Le coefficient imaginaire de l'harmonique de rang j, noté $ImI_{iA,j,k}$, j étant compris entre 2 et J, est la corrélation, sur une durée égale à la période $P_{tension}$, entre les échantillons du signal de l'intensité IiA et un sinus de fréquence égale à j fois la fréquence F.

Les coefficients $ReI_{iA,j,k}$, et $ImI_{iA,j,k}$ vérifient alors les équations suivantes :

$$ \mathrm{ReI}_{iA,j,k} = \sum_{m=1}^{N_{ech}} \mathrm{IiA}_{k,m} \times \cos(2 \times \Pi \times \mathrm{F}_{tension} \times j \times m \times T) \qquad (8) $$

$$ \mathrm{ImI}_{iA,j,k} = \sum_{m=1}^{N_{ech}} \mathrm{IiA}_{k,m} \times \sin(2 \times \Pi \times \mathrm{F}_{tension} \times j \times m \times T) \qquad (9) $$

Le deuxième logiciel de calcul 124A calcule alors, au cours de cette étape 340, les paramètres de surveillance, par exemple la phase angulaire de l'intensité à l'aide de l'équation suivante :

$$ \varphi_{i,j,k}(I_A) = \arctan\left( \frac{\mathrm{Im}\, I_{iA,j,k}}{\mathrm{Re}\, I_{iA,j,k}} \right) \qquad (10) $$

où $\varphi_{i,j,k}(I_A)$ est la phase angulaire de l'intensité $I_A$ pour la phase d'indice i, l'harmonique de rang j, la période de tension $P_{tension}$ d'indice k,
$ReI_{iA,j,k}$, $ImI_{iA,j,k}$ représentent des coefficients réel et imaginaire d'une décomposition en série de Fourier de l'intensité $I_A$ pour la phase d'indice i, l'harmonique de rang j, et la période de tension $P_{tension}$ d'indice k ; c'est-à-dire de l'intensité IiA pour l'harmonique de rang j, et la période de tension $P_{tension}$ d'indice k.

La phase angulaire $\varphi_{i,j,k}(I_A)$ de l'intensité $I_A$ est de préférence calculée seulement pour la première période de tension $P_{tension}$ d'indice 1.

La phase angulaire $\varphi_{i,j,k}(I_A)$ de l'intensité $I_A$ est de préférence calculée seulement pour les harmoniques de rang j respectivement égal à 1, 3 et 5.

En complément, le deuxième logiciel de calcul 124A calcule le module de l'intensité à l'aide de l'équation suivante :

$$ \left\| I_{iA,j,k} \right\| = \sqrt{ \frac{ \left( \mathrm{Re}\, I_{iA,j,k} \right)^2 + \left( \mathrm{Im}\, I_{iA,j,k} \right)^2 }{2} } \qquad (11) $$

où $\|I_{iA,j,k}\|$ est le module, au sens mathématique, de l'intensité $I_A$ pour la phase d'indice i, l'harmonique de rang j, la période de tension $P_{tension}$ d'indice k,

Re$U_{i,j,k}$, Im$U_{i,j,k}$ représentent des coefficients réel et imaginaire d'une décomposition en série de Fourier de l'intensité $I_A$ pour la phase d'indice i, l'harmonique de rang j, et la période de tension $P_{tension}$ d'indice k.

Le module $\|U_{i,j,k}\|$ de la tension est de préférence calculé pour les périodes de tension $P_{tension}$ d'indice k compris entre 1 et $K_{max,I}$, $K_{max,I}$ étant par exemple égal à 10.

Le module $\|U_{i,j,k}\|$ de la tension est de préférence calculé pour les harmoniques de rang j respectivement égal à chacune des valeurs impaires comprises entre 1 et J.

En complément facultatif, le deuxième logiciel de calcul 124A calcule une valeur moyenne $Irms_{i,k}$ de l'intensité sur l'ensemble des harmoniques prises en compte, c'est-à-dire les harmoniques de rang j compris entre 1 et J, pour la phase d'indice i et la période de tension $P_{tension}$ d'indice k, à l'aide de l'équation suivante :

$$Irms_{i,k} = \sqrt{\sum_{j=1}^{J}\left\|I_{iA,j,k}\right\|^2} \tag{12}$$

Le deuxième dispositif 62A élabore alors, lors de l'étape 350, son deuxième message M2A. Le deuxième message M2A contient l'identifiant du deuxième dispositif 62A, l'ensemble des paramètres de surveillance de l'intensité $\varphi_{i,j,k}(I_A)$, $\|I_{iA,j,k}\|$ déterminés précédemment lors de l'étape 340, ainsi que les valeurs moyennes de l'intensité $Irms_{i,k}$ le cas échéant.

Dans l'hypothèse où l'identifiant du deuxième dispositif 62A était contenu dans le premier message M1 reçu précédemment, le deuxième dispositif 62A émet alors lors de l'étape 360 son deuxième message M2A à l'aide de son logiciel d'émission 128A. Dans le cas contraire, le deuxième dispositif 62A retourne directement à l'étape 310 de réception du premier message M1, et émettra son deuxième message M2A lorsque le premier message M1 contiendra son identifiant indiquant alors que l'unique jeton lui aura été attribué afin de l'autoriser à émettre son deuxième message M2A.

Après l'étape d'émission 360 dans le cas où le jeton avait été attribué au deuxième dispositif 62A, ou bien après l'étape 340 autrement, le deuxième dispositif 62A retourne à l'étape de réception 310 si le compteur a atteint la valeur correspondant à la période d'émission $P_{émission}$, ou bien à l'étape de mesure 330 autrement.

Les étapes du procédé de calcul mises en œuvre par les autres deuxièmes dispositifs 62B, ..., 62N sont identiques aux étapes 300 à 360 décrites précédemment pour le deuxième dispositif avec la référence 62A, et sont réalisées en outre de manière simultanée entre tous les deuxièmes dispositifs 62A, ..., 62N de par la synchronisation temporelle effectuée à l'aide du premier message M1.

Lors de l'étape d'émission 360, le seul deuxième dispositif parmi l'ensemble des deuxièmes dispositifs 62A, ..., 62N autorisé à émettre son deuxième message est le deuxième dispositif dont l'identifiant est contenu dans le premier message M1 reçu lors de l'étape de réception 310 précédente. Le logiciel de distribution 108 détermine selon un ordre croissant les identifiants contenus dans le premier message M1 afin d'attribuer successivement l'unique jeton aux deuxièmes dispositifs 62A, ..., 62N. Autrement dit, chaque deuxième dispositif 62A, ..., 62N émet toutes les N secondes son deuxième message M2A, ..., M2N respectif.

Comme représenté sur la figure 6, lors de l'étape 400, le dispositif de centralisation 64 reçoit, à l'aide de son logiciel de réception 140, le premier message additionnel M'1 du premier dispositif 60 et le deuxième message du deuxième dispositif autorisé à émettre selon le mécanisme de jeton distribué, par exemple le message M2A.

Lors de l'étape 410, le dispositif de centralisation 64 enregistre ensuite dans sa base de données 88 les valeurs reçues et contenues dans le premier message additionnel M'1 et dans le deuxième message M2A, par l'intermédiaire de son logiciel d'enregistrement 142. En complément, le logiciel de traitement 144 effectue un horodatage des données enregistrées.

Le logiciel de traitement 144 calcule alors l'énergie active $E_{active1}$, $E_{active2}$, $E_{active3}$ pour chacune des trois phases à partir de l'ensemble des paramètres de surveillance calculés, précédemment reçu du premier dispositif 60 via le premier additionnel M'1 et le deuxième message M2A. La période de calcul des énergies actives $E_{active,1}$, $E_{active,2}$, $E_{active,3}$ est égale à la période d'émission du premier message $P_{émission}$, soit par exemple 1 s. En complément, le logiciel de traitement 144 calcule alors l'énergie réactive $E_{réactive,1}$, $E_{réactive,2}$, $E_{réactive,3}$, voire l'énergie apparente $E_{apparente,1}$, $E_{apparente,2}$, $E_{apparente,3}$ pour chacune des trois phases à partir également de l'ensemble des paramètres de surveillance calculés.

Le logiciel de traitement 144 forme alors un logiciel de calcul de l'énergie électrique pour chacune des trois phases à partir de l'ensemble des paramètres de surveillance calculés.

Pour le calcul de ces énergies, le logiciel de traitement 144 commence par calculer le déphasage entre courant et tension à l'aide des phases angulaires calculées, selon l'équation suivante :

$$\varphi_{i,j,k} = \varphi_{i,j,k}(I_A) - \varphi_{i,j,k}(U) \tag{13}$$

où $\varphi_{i,j,k}$ est le déphasage entre courant et tension pour la phase d'indice i, l'harmonique de rang j, la période de tension $P_{tension}$ d'indice k.

D'après ce qui précède, le déphasage entre courant et tension $\varphi_{i,j,k}$ est de préférence calculé seulement pour la première période de tension $P_{tension}$ d'indice 1.

Le déphasage entre courant et tension $\varphi_{i,j,k}$ est de préférence calculé seulement pour les harmoniques de rang j respectivement égal à 1, 3 et 5.

Dans l'hypothèse où la valeur moyenne Irms$_{i,k}$ de l'intensité n'a pas été calculée précédemment lors de l'étape 340, le logiciel de traitement 144 la calcule lors de cette étape 420 à l'aide de l'équation (12) précitée.

Le logiciel de traitement 144 calcule ensuite une valeur moyenne Im$_{iA,j}$ de l'intensité sur l'ensemble des périodes de tension $P_{tension}$ prises en compte, c'est-à-dire les périodes de tension $P_{tension}$ d'indice k compris entre 1 et $K_{max,I}$, pour la phase d'indice i et l'harmonique de rang j, à l'aide de l'équation suivante :

$$\mathrm{Im}_{iA,j} = \frac{\sum_{k=1}^{K_{max,I}} \left\| I_{iA,j,k} \right\|}{K_{max,I}} \tag{14}$$

Le logiciel de traitement 144 calcule ensuite une valeur moyenne Um$_{i,j}$ de la tension sur l'ensemble des périodes de tension $P_{tension}$ prises en compte, c'est-à-dire les périodes de tension $P_{tension}$ d'indice k compris entre 1 et $K_{max,U}$, pour la phase d'indice i et l'harmonique de rang j, à l'aide de l'équation suivante :

$$Um_{i,j} = \frac{\sum_{k=1}^{K_{max,U}} \left\| U_{i,j,k} \right\|}{K_{max,U}} \tag{15}$$

Le logiciel de traitement 144 calcule alors la puissance active $P_{i,j}$ pour chaque phase numéro i, i étant égal à 1, 2 ou 3, et pour chaque harmonique de rang j respectivement égal à 1, 3 et 5, à l'aide de l'équation suivante :

$$P_{i,j} = Um_{i,j} \times \mathrm{Im}_{iA,j} \times \cos(\varphi_{i,j,1}) \tag{16}$$

Le logiciel de traitement 144 calcule également la puissance réactive $Q_{i,j}$ pour chaque phase numéro i, i étant égal à 1, 2 ou 3, et pour chaque harmonique de rang j respectivement égal à 1, 3 et 5, à l'aide de l'équation suivante :

$$Q_{i,j} = Um_{i,j} \times \mathrm{Im}_{iA,j} \times \sin(\varphi_{i,j,1}) \tag{17}$$

Le logiciel de traitement 144 calcule en outre la puissance apparente $S_{i,j}$ pour chaque phase numéro i, i étant égal à 1, 2 ou 3, et pour chaque harmonique de rang j respectivement égal à 1, 3 et 5, à l'aide de l'équation suivante :

$$S_{i,j} = Um_{i,j} \times \mathrm{Im}_{iA,j} \tag{18}$$

Les énergies active $E_{active,i}$, réactive $E_{réactive,i}$ et apparente $E_{apparente,i}$ de chaque phase d'indice i sont enfin calculées à l'aide des équations suivantes :

$$E_{active,i} = (P_{i,1} + P_{i,3} + P_{i,5}) \times P_{émission} \tag{19}$$

$$E_{réactive,i} = (Q_{i,1} + Q_{i,3} + Q_{i,5}) \times P_{émission} \tag{20}$$

$$E_{apparente,i} = (S_{i,1} + S_{i,3} + S_{i,5}) \times P_{émission} \qquad (21)$$

Le calcul des énergies active $E_{active,i}$, réactive $E_{réactive,i}$ et apparente $E_{apparente,i}$ est effectué à n'importe quel moment au cours d'une période d'émission $P_{émission}$ entre deux réceptions de message M1, les informations nécessaires au calcul étant contenues dans le premier message additionnel M'1 et le deuxième message M2A reçus précédemment, étant donné que les valeurs relatives aux tension et intensités prises en compte correspondent à la période d'émission $P_{émission}$ précédente. Dans l'exemple de la figure 8, le calcul des énergies active $E_{active,i}$, réactive $E_{réactive,i}$ et apparente $E_{apparente,i}$ est effectué sensiblement au milieu de la période d'émission.

Les grandeurs mesurées et calculées par le système de surveillance 20, notamment les énergies active $E_{active,i}$, réactive $E_{réactive,i}$ et apparente $E_{apparente,i}$ de chaque phase d'indice i compris entre 1 et 3, sont ensuite affichées sur l'écran de l'interface homme-machine 90 du dispositif de centralisation par l'intermédiaire du logiciel d'affichage 146 lors de l'étape 430. Ces grandeurs sont affichées sous forme de valeurs numériques et/ou sous forme de courbes.

Le dispositif de centralisation 64 transmet enfin, lors de l'étape 440 et à l'aide de son logiciel de transmission 148, ces grandeurs mesurées et calculées au serveur distant, non représenté. Le serveur distant est propre à effectuer une gestion centralisée des grandeurs mesurées et calculées pour chaque système de calcul 20.

A l'issue de l'étape 440, le dispositif de centralisation 64 retourne à l'étape 400, afin de recevoir le prochain premier message additionnel M'1 du premier dispositif et le deuxième message du deuxième dispositif autorisé à émettre la prochaine fois selon le mécanisme de jeton distribué, par exemple le message M2A.

Le système de surveillance 20 selon l'invention permet ainsi de calculer les énergies active $E_{active,i}$, réactive $E_{réactive,i}$ et apparente $E_{apparente,i}$ directement sur la période d'émission $P_{émission}$ donnée et en fonction de l'ensemble des paramètres de surveillance $\varphi_{i,j,k}(U)$, $\|U_{i,j,k}\|$, respectivement $\varphi_{i,j,k}(I_A)$, $\|I_{iA,j,k}\|$ calculés par le premier dispositif 60 et respectivement le deuxième dispositif 62A. Le système de surveillance 20 permet en outre de réduire la quantité de données transmises via les messages M1, M'1, M2A, ..., M2N, et également de diminuer les calculs effectués par le deuxième dispositif de surveillance 62A qui est autoalimenté. En effet, le deuxième dispositif de surveillance 62A calcule seulement les paramètres de surveillance de l'intensité $\varphi_{i,j,k}(I_A)$, $\|I_{iA,j,k}\|$, et le calcul des énergies active $E_{active,1}$, réactive $E_{réactive,i}$ et apparente $E_{apparente,i}$ est ensuite effectué par le dispositif de centralisation 64.

Le système de surveillance 20 selon l'invention est ainsi moins consommateur de bande passante pour les liaisons radioélectriques entre les différents dispositifs 60, 62A, ..., 62N, 64, tout en étant également moins consommateur d'énergie pour les dispositifs qui sont autoalimentés, à savoir les deuxièmes dispositifs de surveillance 62A, ..., 62N.

Le système de surveillance 20 selon l'invention permet en outre d'obtenir une mesure très précise des énergies active $E_{active,1}$, réactive $E_{réactive,i}$ et apparente $E_{apparente,i}$ pour les trois phases du courant triphasé, de par la synchronisation temporelle de chaque capteur de courant 76A par rapport au module de mesure de la tension 66.

La synchronisation temporelle est très précise, le décalage de synchronisation mesuré étant de l'ordre de plus ou moins 400 nanosecondes avec la technologie actuelle des émetteurs-récepteurs radioélectriques 70, 80A, ..., 80N, 92 et des unités de traitement d'information 68, 78A, ..., 78N, 86.

L'ensemble des dispositifs 60, 62A, ..., 62N, 64 sont reliés entre eux par des liaisons radioélectriques par l'intermédiaire de leur émetteur-récepteur radioélectrique 70, 82A, ..., 82N, 92 respectif, ce qui permet de faciliter l'installation du système de surveillance 20 dans le poste de transformation 10.

La compression des données relatives aux tensions et aux intensités mesurées à l'aide des logiciels de détermination 104, 124A, ..., 124N et la transmission réduite de données entre les différents dispositifs 60, 62A, ..., 62N, 64 permet en outre de réduire la sensibilité du système de surveillance 20 à des perturbations radioélectriques de type brouillage ou perturbation de compatibilité électromagnétique, également appelée perturbation CEM.

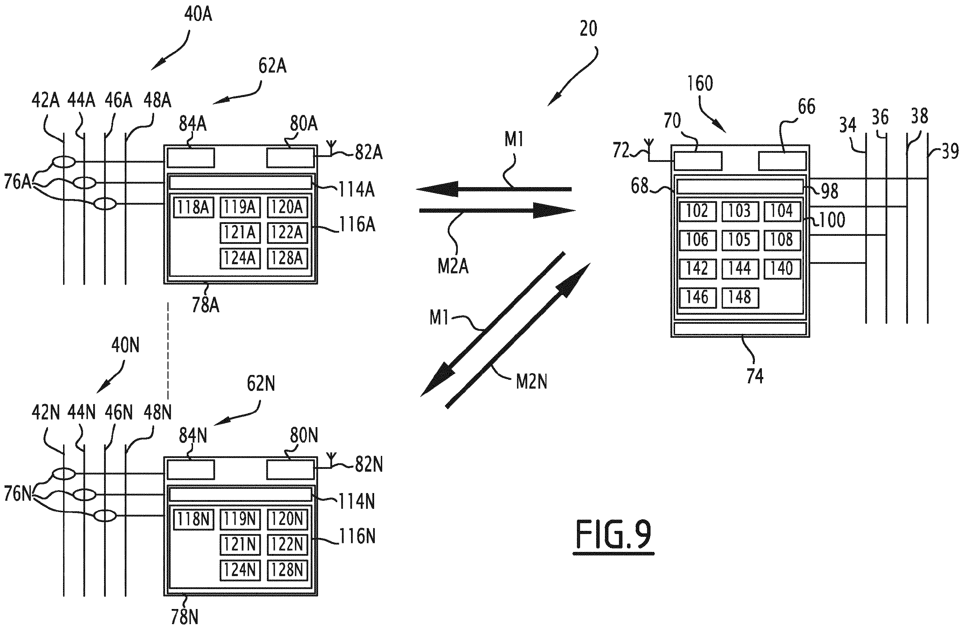

Selon un deuxième mode de réalisation, visible sur la figure 9, le premier dispositif 60 et le dispositif de centralisation 64 sont regroupés dans un même dispositif commun 160, ce qui permet notamment d'avoir un unique émetteur-récepteur radioélectrique 70 pour ledit dispositif commun 160 en lieu et place des deux émetteurs-récepteurs radioélectriques 70, 92 du premier dispositif et du dispositif de centralisation.

Selon ce deuxième mode de réalisation, le dispositif commun 160 comporte le module 66 de mesure de la tension du courant circulant dans le conducteur primaire 34, 36, 38 correspondant, et l'unité de traitement d'informations 68. Le premier dispositif 60 comporte l'émetteur-récepteur radioélectrique 70, l'antenne radioélectrique 72, et le module 74 d'alimentation électrique du module de mesure, de l'unité de traitement d'informations et de l'émetteur-récepteur radioélectrique.

Selon ce deuxième mode de réalisation, la mémoire 100 du premier dispositif est alors apte à stocker le premier logiciel d'acquisition 102, le premier logiciel d'échantillonnage 103, le premier logiciel de détermination 104, le premier logiciel d'émission 105, le premier logiciel de calcul 106, le logiciel de distribution du jeton distribué 108. La mémoire 100 est également apte à stocker le logiciel de réception 140, le logiciel d'enregistrement 142, le logiciel de traitement 144, le logiciel d'affichage 146, et le logiciel de transmission 148.

L'homme du métier comprendra bien entendu que selon ce deuxième mode de réalisation, le premier logiciel d'émission 105 est configuré pour envoyer seulement le premier message principal M1 à destination de chaque deuxième dispositif 62A, ..., 62N, aucun premier message additionnel n'étant émis selon ce deuxième mode de réalisation. De manière analogue, le logiciel de réception 140 est configuré pour recevoir seulement les deuxièmes messages M2A,..., M2N.

L'homme du métier notera également qu'en variante de ce deuxième mode de réalisation le premier logiciel de calcul 106 et le logiciel de traitement 144 forment un unique logiciel de calcul configure pour calculer à la fois les paramètres de surveillance de la tension, puis les valeurs des énergies en fonction des paramètres de surveillance de la tension calculés précédemment et des paramètres de surveillance de l'intensité contenus dans le deuxième message M2A,..., M2N correspondant reçu.

Le fonctionnement de ce deuxième mode de réalisation est analogue à celui du premier mode de réalisation décrit précédemment en regard des organigrammes des figures 4 à 6, et n'est pas décrit à nouveau. Les organigrammes des figures 4 et 6 sont mis en œuvres par le dispositif commun 160.

Les avantages de ce deuxième mode de réalisation comportent ceux du premier mode de réalisation décrit précédemment. Le système de surveillance selon ce deuxième mode de réalisation permet en outre de proposer un système plus simple, moins coûteux et avec une consommation propre d'énergie électrique plus faible.

## Revendications

1. Dispositif électronique (60 ; 62A, ..., 62N) de surveillance d'une grandeur électrique (X) parmi une tension (U1, U2, U3) et une intensité (I1A, ..., I3N) relative à un courant alternatif circulant dans un conducteur électrique (34, 36, 38 ; 42A, 44A, 46A, ..., 42N, 44N, 46N), le courant alternatif comportant au moins une phase, le dispositif comprenant :

   - un module de mesure (66 ; 76A, ..., 76N) configuré pour mesurer au moins une valeur de la grandeur électrique (X),
   - un émetteur-récepteur radioélectrique (70 ; 80A, ..., 80N),
   - un module d'émission (105 ; 128A, ..., 128N) relié à l'émetteur-récepteur radioélectrique (70 ; 80A, ..., 80N), et
   - un module de calcul (106 ; 124A, ..., 124N) configuré pour calculer au moins un paramètre ($\varphi_{i,j,k}(X)$, $\|X_{i,j,k}\|$) de surveillance de la grandeur électrique (X) en fonction d'au moins une valeur mesurée de ladite grandeur électrique,

   **caractérisé en ce que** chaque paramètre de surveillance ($\varphi_{i,j,k}(X)$, $\|X_{i,j,k}\|$) est choisi parmi une phase angulaire de la grandeur électrique ($\varphi_{i,j,k}(X)$) et un module de la grandeur électrique ($\|X_{i,j,k}\|$),
   le module d'émission (105 ; 128A, ..., 128N) étant configuré pour émettre, à destination d'un autre dispositif électronique, un message de données (M1 ; M2A, ..., M2N) contenant au moins un paramètre de surveillance calculé ($\varphi_{i,j,k}\|X_{i,j,k}\|$);
   le module de calcul (106 ; 124A, ..., 124N) étant configuré pour calculer la phase angulaire ($\varphi_{i,j,k}(X)$) de la grandeur électrique (X), pour la ou chaque phase d'indice i, suivant l'équation :

$$\varphi_{i,j,k}(X) = \arctan\left(\frac{\mathrm{Im}\,X_{i,j,k}}{\mathrm{Re}\,X_{i,j,k}}\right)$$

   où $\mathrm{Re}\,X_{i,j,k}$, $\mathrm{Im}\,X_{i,j,k}$ représentent des coefficients réel et imaginaire d'une décomposition en série de Fourier de la grandeur électrique (X),
   i est l'indice de la phase correspondante,
   j est le rang de l'harmonique pour la décomposition en série de Fourier, le fondamental étant de rang égal à 1, et
   k est un indice d'une période de tension $P_{\mathrm{tension}}$ au cours de laquelle la valeur de la grandeur électrique (X) est mesurée ;

   le module de calcul (106 ; 124A, ..., 124N) étant configuré pour calculer le module ($\|X_{i,j,k}\|$) de la grandeur électrique (X), pour la ou chaque phase d'indice i, suivant l'équation :

$$\left\| X_{i,j,k} \right\| = \sqrt{\frac{\left(\text{Re } X_{i,j,k}\right)^2 + \left(\text{Im } X_{i,j,k}\right)^2}{2}}$$

où Re$X_{i,j,k}$, Im$X_{i,j,k}$ représentent des coefficients réel et imaginaire d'une décomposition en série de Fourier de la grandeur électrique (X),

i est l'indice de la phase correspondante,

j est le rang de l'harmonique pour la décomposition en série de Fourier, le fondamental étant de rang égal à 1, et

k est un indice d'une période de tension $P_{tension}$ au cours de laquelle la valeur de la grandeur électrique (X) est mesurée.

2. Dispositif (60 ; 62A, ..., 62N) selon la revendication précédente, dans lequel le dispositif (60 ; 62A, ..., 62N ; 160) comprend en outre un module (103 ; 119A, ..., 119N) d'échantillonnage de la valeur de la grandeur électrique mesurée (X) suivant une période d'échantillonnage ($P_{ech}$).

3. Système électronique (20) de surveillance d'un tableau électrique (16) comportant au moins un conducteur électrique primaire de départ (34, 36, 38) et au moins un conducteur électrique secondaire de départ (42A, ..., 46N), le ou chaque conducteur secondaire de départ (42A, ..., 46N) étant connecté électriquement à un conducteur primaire de départ (34 ; 36 ; 38) correspondant, les conducteurs de départ (34, 42A, 42B, .., 38, 46A, 46B, ..., 46N) correspondants présentant une tension alternative, le système comprenant :

- un premier dispositif électronique (60 ; 160) de surveillance de la tension (U1, U2, U3) de chaque conducteur électrique primaire de départ (34, 36, 38),
- au moins un deuxième dispositif électronique (62A, ..., 62N) de surveillance de l'intensité (I1A, ..., I3N) du courant alternatif circulant dans chaque conducteur électrique secondaire (42A, ..., 46N),

**caractérisé en ce qu'**au moins un des dispositifs électroniques de surveillance (60, 62A, ..., 62N) est selon l'une quelconque des revendications précédentes.

4. Système (20) selon la revendication 3, dans lequel le module de mesure (66) du premier dispositif de surveillance est configuré pour mesurer en outre la fréquence (F) de la tension, et le message (M1) émis par le module d'émission (105) du premier dispositif de surveillance contient en outre une valeur mesurée de la fréquence (F).

5. Système (20) selon la revendication 4, dans lequel chaque deuxième dispositif de surveillance (62A, ..., 62N) comporte en outre un module (119A, ..., 119N) d'échantillonnage de la valeur de l'intensité mesuré (I1A, ..., I3N) suivant une période d'échantillonnage ($P_{ech}$) et un module de réception du message (M1) émis par le module d'émission (105) du premier dispositif de surveillance, le module de réception étant relié à l'émetteur-récepteur radioélectrique (80A, ..., 80N), et

dans lequel la valeur de la période d'échantillonnage ($P_{ech}$) est fonction de la valeur mesurée de la fréquence de la tension (F), contenue dans le dernier message (M1) reçu du module d'émission (105) du premier dispositif de surveillance (60).

6. Système (20) selon l'une quelconque des revendications 3 à 5, dans lequel le système (20) comprend en outre un dispositif électronique de centralisation (64) configuré pour recevoir les messages de données (M'1, M2A, ..., M2N) émis par le premier dispositif de surveillance (60) et par chaque deuxième dispositif de surveillance (62A, ..., 62N), le dispositif électronique de centralisation (64) étant en outre configuré pour calculer l'énergie électrique ($E_{active,i}$, $E_{réactive,i}$, $E_{apparente,i}$) du courant alternatif circulant dans chaque conducteur électrique secondaire (42A, ..., 46N) à partir des paramètres de surveillance calculés par le premier dispositif de surveillance (60) et par chaque deuxième dispositif de surveillance (62A, ..., 62N), ces paramètres de surveillance calculés étant contenus dans les messages de données (M'1, M2A, ..., M2N) reçus.

7. Système selon l'une quelconque des revendications 3 à 5, dans lequel le premier dispositif de surveillance (60) comporte en outre un module de réception du message (M2A, ..., M2N) émis par le module d'émission (128A, ..., 128N) de chaque deuxième dispositif de surveillance (62A, ..., 62N),

le module de calcul du premier dispositif de surveillance (60) étant en outre configuré pour calculer l'énergie électrique ($E_{active,i}$, $E_{réactive,1}$, $E_{apparente,i}$) du courant alternatif circulant dans chaque conducteur électrique secondaire (42A, ..., 46N) à partir des paramètres de surveillance calculés par lui et par chaque deuxième dispositif de surveillance (62A, ..., 62N), les paramètres de surveillance calculés par chaque deuxième dispositif de surveillance (62A, ..., 62N) étant contenus dans les messages de données (M2A, ..., M2N) reçus par ledit module de réception.

8. Armoire électrique, comprenant :

   - un tableau électrique (16) comportant au moins un conducteur électrique primaire de départ (34, 36, 38) et au moins un conducteur électrique secondaire de départ (42A, ..., 46N), le ou chaque conducteur secondaire de départ (42A, ..., 46N) étant connecté électriquement à un conducteur primaire de départ (34 ; 36 ; 38) correspondant, les conducteurs de départ (34, 42A, 42B, .., 38, 46A, 46B, ..., 46N) correspondants présentant une tension alternative, et
   - un système (20) de surveillance du tableau électrique (16),

   **caractérisé en ce que** le système de surveillance (20) est selon l'une quelconque des revendications 3 à 7.

9. Poste (10) de transformation d'un courant électrique présentant une première tension alternative en un courant électrique présentant une deuxième tension alternative,
   **caractérisé en ce qu'**il comprend une armoire électrique selon la revendication 8, un tableau d'arrivée (14) comportant au moins un conducteur électrique d'arrivée (24A, 26A, 28A, 24B, 26B, 28B) propre à être relié à un réseau électrique (12), le conducteur d'arrivée présentant la première tension alternative, le tableau (16) de l'armoire formant un tableau de départ dont les conducteurs de départ (34, 42A, 42B, .., 38, 46A, 46B, ..., 46N) correspondants présentent la deuxième tension alternative, et
   un transformateur électrique (18) connecté entre le tableau d'arrivée (14) et le tableau de départ (16), le transformateur (18) étant propre à transformer le courant présentant la première tension alternative en le courant présentant la deuxième tension alternative.

10. Procédé de de surveillance d'une grandeur électrique (X) parmi une tension (U1, U2, U3) et une intensité (I1A, ..., I3N) relative à un courant alternatif circulant dans un conducteur électrique (34, 36, 38 ; 42A, 44A, 46A, ..., 42N, 44N, 46N), le courant alternatif comportant au moins une phase,
    le procédé étant mis en œuvre par un dispositif électronique de surveillance (60 ; 62A, ..., 62N), et comprenant les étapes suivantes :

    - a) la mesure (210 ; 330) d'au moins une valeur de la grandeur électrique (X),
    - c) l'émission (230 ; 350) d'un message de données (M1 ; M2A, ..., M2N) à destination d'un autre dispositif électronique (62A, ..., 62N ; 60 ; 64)

    **caractérisé en ce qu'**il comprend en outre, après l'étape a) et préalablement à l'étape c), l'étape suivante :

    - b) le calcul (220 ; 340) d'au moins un paramètre ($\varphi_{i,j,k}(X)$, $\|X_{i,j,k}\|$) de surveillance de la grandeur électrique (X) en fonction d'au moins une valeur mesurée de ladite grandeur électrique (X), chaque paramètre de surveillance ($\varphi_{i,j,k}(X)$, $\|X_{i,j,k}\|$) étant choisi parmi une phase angulaire ($\varphi_{i,j,k}(X)$) de la grandeur électrique (X) et un module ($\|X_{i,j,k}\|$) de la grandeur électrique (X),

    le message de données (M1 ; M2A, ..., M2N) émis contenant au moins un paramètre de surveillance calculé ;
    la phase angulaire ($\varphi_{i,j,k}(X)$) de la grandeur électrique (X) étant calculée, pour la ou chaque phase d'indice i, suivant l'équation :

    $$\varphi_{i,j,k}(X) = \arctan\left(\frac{\operatorname{Im} X_{i,j,k}}{\operatorname{Re} X_{i,j,k}}\right)$$

    où $\operatorname{Re} X_{i,j,k}$, $\operatorname{Im} X_{i,j,k}$ représentent des coefficients réel et imaginaire d'une décomposition en série de Fourier de la grandeur électrique (X),
    i est l'indice de la phase correspondante,
    j est le rang de l'harmonique pour la décomposition en série de Fourier, le fondamental étant de rang égal à 1, et
    k est un indice d'une période de tension $P_{tension}$ au cours de laquelle la valeur de la grandeur électrique (X) est mesurée ;
    le module ($\|X_{i,j,k}\|$) de la grandeur électrique (X) étant calculé, pour la ou chaque phase d'indice i, suivant

l'équation :

$$\left\| X_{i,j,k} \right\| = \sqrt{\frac{\left( \mathrm{Re}\ X_{i,j,k} \right)^2 + \left( \mathrm{Im}\ X_{i,j,k} \right)^2}{2}}$$

où $\mathrm{Re}X_{i,j,k}$, $\mathrm{Im}X_{i,j,k}$ représentent des coefficients réel et imaginaire d'une décomposition en série de Fourier de la grandeur électrique (X),
i est l'indice de la phase correspondante,
j est le rang de l'harmonique pour la décomposition en série de Fourier, le fondamental étant de rang égal à 1, et
k est un indice d'une période de tension $P_{tension}$ au cours de laquelle la valeur de la grandeur électrique (X) est mesurée.

**Patentansprüche**

1. Elektronische Vorrichtung (60; 62A, ..., 62N) zum Überwachen einer elektrischen Größe (X), die eine Spannung (U1, U2, U3) oder eine Stromstärke (I1A, ..., I3N) in Bezug auf einen in einem elektrischen Leiter (34, 36, 38; 42A, 44A, 46A, ..., 42N, 44N, 46N) fließenden Wechselstrom ist, wobei der Wechselstrom mindestens eine Phase aufweist, wobei die Vorrichtung aufweist:

   - ein Messmodul (66; 76A, ..., 76N), das konfiguriert ist, um mindestens einen Wert der elektrischen Größe (X) zu messen,
   - einen Funksender/-empfänger (70; 80A, ..., 80N),
   - ein Sendemodul (105; 128A, ..., 128N), das mit dem Funksender /-empfänger (70; 80A, ..., 80N) verbunden ist, und
   - ein Berechnungsmodul (106; 124A, ..., 124N), das konfiguriert ist, um mindestens einen Überwachungsparameter ($\varphi_{i,j,k}(X)$, $\|X_{i,j,k}\|$) der elektrischen Größe (X) in Abhängigkeit von mindestens einem Messwert der elektrischen Größe zu berechnen,

   **dadurch gekennzeichnet, dass** jeder Überwachungsparameter ($\varphi_{i,j,k}(X)$, $\|X_{i,j,k}\|$) aus einem Phasenwinkel der elektrischen Größe ($\varphi_{i,j,k}(X)$) und einem Betrag der elektrischen Größe ($\|X_{i,j,k}\|$) ausgewählt ist,
   wobei das Sendemodul (105; 128A, ..., 128N) konfiguriert ist, um an eine andere elektronische Vorrichtung eine Datennachricht (M1; M2A, ..., M2N) zu senden, die mindestens einen berechneten Überwachungsparameter ($\varphi_{i,j,k}(X)$, $\|X_{i,j,k}\|$) aufweist,
   wobei das Berechnungsmodul (106; 124A, ..., 124N) konfiguriert ist, um für die oder jede Phase des Indexes i die Winkelphase ($\varphi_{i,j,k}(X)$) der elektrischen Größe (X) zu berechnen gemäß der Gleichung:

$$\varphi_{i,j,k}(X) = \arctan\left( \frac{\mathrm{Im}\ X_{i,j,k}}{\mathrm{Re}\ X_{i,j,k}} \right)$$

   wobei

   $\mathrm{Re}X_{i,j,k}$, $\mathrm{Im}X_{i,j,k}$ reelle und imaginäre Koeffizienten einer Fourierreihenentwicklung der elektrischen Größe (X) darstellen,
   i der Index der entsprechenden Phase ist,
   j die Ordnungszahl der Harmonischen für die Fourierreihenentwicklung ist, wobei die Grundschwingung eine Ordnungszahl gleich 1 hat, und
   k ein Index einer Spannungsperiode $P_{tension}$ ist, während der der Wert der elektrischen Größe (X) gemessen wird;
   wobei das Berechnungsmodul (106; 124A, ..., 124N) konfiguriert ist, für die oder jede Phase des Indexes i den Betrag ($\|X_{i,j,k}\|$) der elektrischen Größe (X) zu berechnen gemäß der Gleichung:

$$\left\| X_{i,j,k} \right\| = \sqrt{\frac{\left( \text{Re } X_{i,j,k} \right)^2 + \left( \text{Im } X_{i,j,k} \right)^2}{2}}$$

wobei

Re$X_{i,j,k}$, Im$X_{i,j,k}$ reelle und imaginäre Koeffizienten einer Fourierreihenentwicklung der elektrischen Größe (X) darstellen,

i der Index der entsprechenden Phase ist,

j die Ordnungszahl der Harmonischen für die Fourierreihenentwicklung ist, wobei die Grundschwingung eine Ordnungszahl gleich 1 hat, und

k ein Index einer Spannungsperiode $P_{tension}$ ist, während der der Wert der elektrischen Größe (X) gemessen wird.

2. Vorrichtung (60; 62A, ..., 62N) nach dem vorhergehenden Anspruch, wobei die Vorrichtung (60; 62A, ..., 62N; 160) ferner ein Modul (103; 119A, ..., 119N) zum Abtasten des Wertes der gemessenen elektrischen Größe (X) gemäß einer Abtastperiode ($P_{ech}$) aufweist.

3. Elektronisches System (20) zum Überwachen einer elektrischen Schalttafel (16) mit mindestens einem primären elektrischen Ausgangspunktleiter (34, 36, 38) und mindestens einem sekundären elektrischen Ausgangspunktleiter (42A, ..., 46N), wobei der oder jeder sekundäre Ausgangspunktleiter (42A, ..., 46N) elektrisch mit einem entsprechenden primären Ausgangspunktleiter (34; 36; 38) verbunden ist, wobei die entsprechenden Ausgangspunktleiter (34, 42A, 42B, ..., 38, 46A, 46B, ..., 46N) eine Wechselspannung aufweisen,
wobei das System aufweist:

- eine erste elektronische Vorrichtung (60; 160) zum Überwachen der Spannung (U1, U2, U3) jedes primären elektrischen Ausgangspunktleiters (34, 36, 38),
- mindestens eine zweite elektronische Vorrichtung (62A, ..., 62N) zum Überwachen der Stromstärke (I1A, ..., I3N) des in jedem sekundären elektrischen Leiter (42A, ..., 46N) fließenden Wechselstroms,

dadurch gekennzeichnet, dass mindestens eine der elektronischen Vorrichtungen (60, 62A, ..., 62N) zum Überwachen nach einem der vorhergehenden Ansprüche ist.

4. System (20) nach Anspruch 3, wobei das Messmodul (66) der ersten Vorrichtung zum Überwachen konfiguriert ist, um ferner die Frequenz (F) der Spannung zu messen, und wobei die Nachricht (M1), die von dem Sendemodul (105) der ersten Vorrichtung zum Überwachen gesendet wird, ferner einen Messwert der Frequenz (F) aufweist.

5. System (20) nach Anspruch 4, wobei jede zweite Vorrichtung zum Überwachen (62A, ..., 62N) ferner ein Modul zum Abtasten (119a, ..., 119N) des Wertes der gemessenen Stromstärke (I1A, ...I3N) gemäß einer Abtastperiode ($P_{ech}$) und ein Modul zum Empfangen der Nachricht (M1), die von dem Sendemodul (105) der ersten Vorrichtung zum Überwachen gesendet wird, aufweist, wobei das Modul zum Empfangen mit dem Funksender/-empfänger (80A, ..., 80N) verbunden ist, und
wobei der Wert der Abtastperiode ($P_{ech}$) abhängig von dem Messwert der Frequenz (F) der Spannung ist, die in der von dem Sendemodul (105) der ersten Vorrichtung zum Überwachen (60) empfangenen letzten Nachricht (M1) enthalten ist.

6. System (20) nach einem der Ansprüche 3 bis 5, wobei das System (20) ferner eine elektronische Zentralisierungsvorrichtung (64) aufweist, die zum Empfangen der Datennachrichten (M'1, M2A, ..., M2N) konfiguriert ist, die von der ersten Vorrichtung zum Überwachen (60) und von jeder zweiten Vorrichtung zum Überwachen (62A, ..., 62N) gesendet werden,
wobei die elektronische Zentralisierungsvorrichtung (64) ferner konfiguriert ist, um die elektrische Energie ($E_{active,i}$, $E_{reactive,i}$, $E_{apparente,i}$) des in jedem sekundären elektrischen Leiter (42A, ..., 46N) fließenden Wechselstroms aus den von der ersten Vorrichtung zum Überwachen (60) und von jeder zweiten Vorrichtung zum Überwachen (62A, ..., 62N) berechneten Parametern zum Überwachen zu berechnen, wobei die berechneten Überwachungsparameter in den empfangenen Datennachrichten (M'1, M2A, ..., M2N) enthalten sind.

7. System nach einem der Ansprüche 3 bis 5, wobei die erste Vorrichtung zum Überwachen (60) ferner ein Modul zum Empfangen der Datennachricht (M2A, ..., M2N) aufweist, die von dem Sendemodul (128A, ..., 128N) jeder zweiten Vorrichtung zum Überwachen (62A, ..., 62N) gesendet wird,

wobei das Berechnungsmodul der ersten Vorrichtung zum Überwachen (60) ferner konfiguriert ist, um die elektrische Energie ($E_{active,i}$, $E_{réactive,i}$, $E_{apparente,i}$) des in jedem sekundären elektrischen Leiter (42A, ..., 46N) fließenden Wechselstroms aus den von ihr und von jeder zweiten Vorrichtung zum Überwachen (62A, ..., 62N) berechneten Parametern zum Überwachen zu berechnen, wobei die von jeder zweiten Vorrichtung zum Überwachen (62A, ..., 62N) berechneten Überwachungsparameter in den von dem Modul zum Empfangen empfangenen Datennachrichten (M2A, ..., M2N) enthalten sind.

8. Elektrischer Schaltschrank, aufweisend:

   - eine elektrische Schalttafel (16) mit mindestens einem primären elektrischen Ausgangspunktleiter (34, 36, 38) und mindestens einem sekundären elektrischen Ausgangspunktleiter (42A, ..., 46N), wobei der oder jeder sekundäre Ausgangspunktleiter (42A, ..., 46N) elektrisch mit einem entsprechenden primären Ausgangspunktleiter (34; 36; 38) verbunden ist, wobei die entsprechenden Ausgangspunktleiter (34, 42A, 42B, .., 38, 46A, 46B , ..., 46N) eine Wechselspannung aufweisen, und
   - ein System zum Überwachen (20) der elektrischen Schalttafel (16),

   **dadurch gekennzeichnet, dass** das System zum Überwachen (20) nach einem der Ansprüche 3 bis 7 ist.

9. Station (10) zum Umwandeln eines elektrischen Stroms mit einer ersten Wechselspannung in einen elektrischen Strom mit einer zweiten Wechselspannung,
   **dadurch gekennzeichnet, dass** sie aufweist:

   einen elektrischen Schaltschrank nach Anspruch 8, eine Ankunftstafel (14) mit mindestens einem elektrischen Ankunftsleiter (24A, 26A, 28A, 24B, 26B, 28B), der an ein elektrisches Netz (12) anschließbar ist,
   wobei der Ankunftsleiter die erste Wechselspannung aufweist, wobei die Schalttafel (16) des Schaltschrankes eine Ausgangspunkttafel bildet, deren entsprechende Ausgangspunktleiter (34, 42A, 42B, .., 38, 46A, 46B, ..., 46N) die zweite Wechselspannung aufweisen, und
   einen zwischen der Ankunftstafel (14) und der Ausgangspunkttafel (16) angeschlossenen elektrischen Transformator (18), wobei der Transformator (18) geeignet ist, den Strom mit der ersten Wechselspannung in den Strom mit der zweiten Wechselspannung umzuwandeln.

10. Verfahren zum Überwachen einer elektrischen Größe (X), die eine Spannung (U1, U2, U3) oder eine Stromstärke (I1A, ..., I3N) in Bezug auf einen in einem elektrischen Leiter (34, 36, 38; 42A, 44A, 46A, ..., 42N, 44N, 46N) fließenden Wechselstrom ist, wobei der Wechselstrom mindestens eine Phase aufweist, wobei das Verfahren durch eine elektronische Vorrichtung zum Überwachen (60; 62A, ..., 62N) durchgeführt wird, und die Schritte aufweist:

    - a) Messen (210; 330) mindestens eines Wertes der elektrischen Größe (X);
    - c) Senden (230; 350) einer Datennachricht (M1, M2A, ..., M2N) an eine andere elektronische Vorrichtung (62A, ..., 62N; 60; 64),

    **dadurch gekennzeichnet, dass** es nach Schritt a) und vor dem Schritt c) ferner den folgenden Schritt aufweist:
    b) Berechnen (220; 340) mindestens eines Überwachungsparameters ($\varphi_{i,j,k(X)}$, $\|X_{i,j,k}\|$) der elektrischen Größe (X) in Abhängigkeit von mindestens einem Messwert der elektrischen Größe, wobei jeder Überwachungsparameter ($\varphi_{i,j,k}(X)$, $\|X_{i,j,k}\|$) aus einem Phasenwinkel ($\varphi_{i,j,k}(X)$) der elektrischen Größe (X) und einem Betrag ($\|X_{i,j,k}\|$) der elektrischen Größe (X) ausgewählt ist,
    wobei die gesendete Datennachricht (M1, M2A, ... M2N) mindestens einen berechneten Überwachungsparameter aufweist,
    wobei für die oder jede Phase des Indexes i der Phasenwinkel ($\varphi_{i,j,k}(X)$) der elektrischen Größe (X) berechnet wird gemäß der Gleichung:

$$\varphi_{i,j,k}(X) = \arctan\left(\frac{\operatorname{Im} X_{i,j,k}}{\operatorname{Re} X_{i,j,k}}\right)$$

wobei

ReX$_{i,j,k}$, ImX$_{i,j,k}$ reelle und imaginäre Koeffizienten einer Fourierreihenentwicklung der elektrischen Größe (X) darstellen,

i der Index der entsprechenden Phase ist,

j die Ordnungszahl der Harmonischen für die Fourierreihenentwicklung ist, wobei die Grundschwingung eine Ordnungszahl gleich 1 hat, und

k ein Index einer Spannungsperiode P$_{tension}$ ist, während der der Wert der elektrischen Größe (X) gemessen wird;

wobei für die oder jede Phase des Indexes i den Betrag (‖Xi,j,k‖) der elektrischen Größe (X) berechnet wird gemäß der Gleichung:

$$\left\| X_{i,j,k} \right\| = \sqrt{\frac{\left( \operatorname{Re} X_{i,j,k} \right)^2 + \left( \operatorname{Im} X_{i,j,k} \right)^2}{2}}$$

wobei

ReX$_{i,j,k}$, ImX$_{i,j,k}$ reelle und imaginäre Koeffizienten einer Fourierreihenentwicklung der elektrischen Größe (X) darstellen,

i der Index der entsprechenden Phase ist,

j die Ordnungszahl der Harmonischen für die Fourierreihenentwicklung ist, wobei die Grundschwingung eine Ordnungszahl gleich 1 hat, und

k ein Index einer Spannungsperiode P$_{tension}$ ist, während der der Wert der elektrischen Größe (X) gemessen wird.

## Claims

1. Electronic device (60; 62A, ..., 62N) for monitoring an electrical quantity (X) from among a voltage (U1, U2, U3) and an intensity (I1A, ..., I3N) relative to an alternating current flowing in an electrical conductor (34, 36, 38; 42A, 44A, 46A, ..., 42N, 44N, 46N), the alternating current having at least one phase, the device comprising:

   - a measurement module (66; 76A, ..., 76N) configured to measure at least one value of the electrical quantity (X),
   - a radioelectric transmitter/receiver (70; 80A, ..., 80N),
   - a transmission module (105; 128A, ..., 128N) connected to the radioelectric transmitter/receiver (70; 80A, ..., 80N),
   and
   - a calculation module (106; 124A, ..., 124N) configured to calculate at least one parameter ($\varphi_{i,j,k}$(X), ‖X$_{i,j,k}$‖) for monitoring the electrical quantity (X) as a function of at least one measured value of said electrical quantity,

   **characterised in that** each monitoring parameter ($\varphi_{i,j,k}$(X), ‖X$_{i,j,k}$‖)is chosen from among an angular phase of the electrical quantity ($\varphi_{i,j,k}$(X)) and a modulus of the electrical quantity (‖X$_{i,j,k}$‖),

   the transmission module (105; 128A, ..., 128N) being configured to transmit, to another electronic device, a data message (M1; M2A, ..., M2N) containing at least one calculated monitoring parameter ($\varphi_{i,j,k}$(X), ‖X$_{i,j,k}$‖);

   the calculation module (106; 124A, ..., 124N) being configured to calculate the angular phase ($\varphi_{i,j,k}$(X)) of the electrical quantity (X), for the or each phase of index i, according to the equation:

$$\varphi_{i,j,k}(X) = \arctan\left(\frac{\operatorname{Im} X_{i,j,k}}{\operatorname{Re} X_{i,j,k}}\right)$$

   wherein Re$X_{i,j,k}$, Im$X_{i,j,k}$ represent real and imaginary coefficients of a Fourier series decomposition of the electrical quantity (X),

   i is the index of the corresponding phase,

   j is the rank of the harmonic for the Fourier series decomposition, the fundamental being of rank equal to 1, and

   k is an index of a voltage period P$_{voltage}$ during which the value of the electrical quantity (X) is measured;

   the calculation module (106; 124A, ..., 124N) being configured to calculate the modulus (‖X$_{i,j,k}$‖) of the electrical quantity (X), for the or each phase of index i, according to the equation:

$$\| X_{i,j,k} \| = \sqrt{\frac{\left(\mathrm{Re}\, X_{i,j,k}\right)^2 + \left(\mathrm{Im}\, X_{i,j,k}\right)^2}{2}}$$

wherein $\mathrm{Re} X_{i,j,k}$, $\mathrm{Im} X_{i,j,k}$ represent real and imaginary coefficients of a Fourier series decomposition of the electrical quantity (X),
i is the index of the corresponding phase,
j is the rank of the harmonic for the Fourier series decomposition, the fundamental being of rank equal to 1, and
k is an index of a voltage period $P_{voltage}$ during which the value of the electrical quantity (X) is measured.

2. Device (60; 62A, ..., 62N) according to the preceding claim, wherein the device (60; 62A, ..., 62N; 160) further comprises a module (103; 119A, ..., 119N) for sampling the value of the measured electrical quantity (X) according to a sampling period (Psam).

3. Electronic system (20) for monitoring an electrical panel (16) having at least one primary outgoing electrical conductor (34, 36, 38) and at least one secondary outgoing electrical conductor (42A, ..., 46N), the or each secondary outgoing conductor (42A, ..., 46N) being electrically connected to a corresponding primary outgoing conductor (34; 36; 38), the corresponding outgoing conductors (34, 42A, 42B, ..., 38, 46A, 46B, ..., 46N) having an alternating voltage, the system comprising:

   - a first electronic device (60; 160) for monitoring the voltage (U1, U2, U3) of each primary outgoing electrical conductor (34, 36, 38),
   - at least one second electronic device (62A, ..., 62N) for monitoring the intensity (I1A, ..., I3N) of the alternating current flowing in each secondary electrical conductor (42A, ..., 46N),

   **characterised in that** at least one of the electronic monitoring devices (60, 62A, ..., 62N) is in accordance with any one of the preceding claims.

4. System (20) according to claim 3, wherein the measurement module (66) of the first monitoring device is configured to further measure the frequency (F) of the voltage, and the message (M1) transmitted by the transmission module (105) of the first monitoring device further contains a measured value of the frequency (F).

5. System (20) according to claim 4, wherein each second monitoring device (62A, ..., 62N) further comprises a module (119A, ..., 119N) for sampling the value of the measured intensity (I1A, ..., I3N) according to a sampling period ($P_{sam}$) and a module for receiving the message (M1) transmitted by the transmission module (105) of the first monitoring device, the receiving module being connected to the radioelectric transmitter/receiver (80A, ..., 80N), and wherein the value of the sampling period ($P_{sam}$) is a function of the measured value of the frequency of the voltage (F), contained in the last message (M1) received from the transmission module (105) of the first monitoring device (60).

6. System (20) according to any one of claims 3 to 5, wherein the system (20) further comprises an electronic centralisation device (64) configured to receive the data messages (M'1, M2A, ..., M2N) transmitted by the first monitoring device (60) and by each second monitoring device (62A, ..., 62N), the electronic centralisation device (64) further being configured to calculate the electrical energy ($E_{active,i}$, $E_{réactive,i}$, $E_{apparent,i}$) of the alternating current flowing in each secondary electrical conductor (42A, ..., 46N) from the monitoring parameters calculated by the first monitoring device (60) and by each second monitoring device (62A, ..., 62N), the calculated monitoring parameters being contained in the received data messages (M'1, M2A, ..., M2N).

7. System according to any one of claims 3 to 5, wherein the first monitoring device (60) further comprises a module for receiving the message (M2A, ..., M2N) transmitted by the transmission module (128A, ..., 128N) of each second monitoring device (62A, ..., 62N), the calculation module of the first monitoring device (60) further being configured to calculate the electrical energy ($E_{active,i}$, $E_{réactive,i}$, $E_{apparent,i}$) of the alternating current flowing in each secondary electrical conductor (42A, ..., 46N) from the monitoring parameters calculated by it and by each second monitoring device (62A, ..., 62N), the monitoring parameters calculated by each second monitoring device (62A, ..., 62N) being contained in the data messages (M2A, ..., M2N) received by said receiving module.

8. Electrical cabinet, comprising:

- an electrical panel (16) having at least one primary outgoing electrical conductor (34, 36, 38) and at least one secondary outgoing electrical conductor (42A, ..., 46N), the or each secondary outgoing electrical conductor (42A, ..., 46N) being electrically connected to a corresponding primary outgoing conductor (34; 36; 38), the corresponding outgoing conductors (34, 42A, 42B, ..., 38, 46A, 46B, ..., 46N) having an alternating voltage, and
- a system (20) for monitoring the electrical panel (16),

**characterised in that** the monitoring system (20) is in accordance with any one of claims 3 to 7.

9. Station (10) for transforming an electrical current having a first alternating voltage into an electrical current having a second alternating voltage,
   **characterised in that** it comprises an electrical cabinet according to claim 8, an incoming panel (14) having at least one incoming electrical conductor (24A, 26A, 28A, 24B, 26B, 28B) capable of being connected to an electric network (12), the incoming conductor having the first alternating voltage, the panel (16) of the cabinet forming an outgoing panel, the corresponding outgoing conductors (34, 42A, 42B, ..., 38, 46A, 46B, ..., 46N) of which have the second alternating voltage, and
   an electric transformer (18) connected between the incoming panel (14) and the outgoing panel (16), the transformer (18) being capable of transforming the current having the first alternating voltage into the current having the second alternating voltage.

10. Method for monitoring an electrical quantity (X) from among a voltage (U1, U2, U3) and an intensity (I1A, ..., I3N) relative to an alternating current flowing in an electrical conductor (34, 36, 38; 42A, 44A, 46A, ..., 42N, 44N, 46N), the alternating current having at least one phase,
    the method being carried out by an electronic monitoring device (60; 62A, ..., 62N) and comprising the following steps:

    - a) measuring (210; 330) at least one value of the electrical quantity (X),
    - c) transmitting (230; 350) a data message (M1; M2A, ..., M2N) to another electronic device (62A, ..., 62N; 60; 64),

    **characterised in that** it further comprises, after step a) and before step c), the following step:

    - b) calculating (220; 340) at least one parameter (($\varphi_{i,j,k}(X)$, $\|X_{i,j,k}\|$)for monitoring the electrical quantity (X) as a function of at least one measured value of said electrical quantity (X), each monitoring parameter ($\varphi_{i,j,k}(X)$, $\|X_{i,j,k}\|$) being chosen from among an angular phase ($\varphi_{i,j,k}(X)$) of the electrical quantity (X) and a modulus ($\|X_{i,j,k}\|$) of the electrical quantity (X),

    the transmitted data message (M1; M2A, ..., M2N) containing at least one calculated monitoring parameter;
    the angular phase ($\varphi_{i,j,k}(X)$) of the electrical quantity (X) being calculated, for the or each phase of index i, according to the equation:

    $$\varphi_{i,j,k}(X) = \arctan\left(\frac{\operatorname{Im} X_{i,j,k}}{\operatorname{Re} X_{i,j,k}}\right)$$

    wherein Re$X_{i,j,k}$, Im$X_{i,j,k}$ represent real and imaginary coefficients of a Fourier series decomposition of the electrical quantity (X),
    i is the index of the corresponding phase,
    j is the rank of the harmonic for the Fourier series decomposition, the fundamental being of rank equal to 1, and
    k is an index of a voltage period $P_{voltage}$ during which the value of the electrical quantity (X) is measured;
    the modulus ($\|X_{i,j,k}\|$) of the electrical quantity (X) being calculated, for the or each phase of index i, according to the equation:

    $$\| X_{i,j,k} \| = \sqrt{\frac{\left(\operatorname{Re} X_{i,j,k}\right)^2 + \left(\operatorname{Im} X_{i,j,k}\right)^2}{2}}$$

    wherein $ReX_{i,y,k}$, Im$X_{i,j,k}$ represent real and imaginary coefficients of a Fourier series decomposition of the electrical quantity (X),
    i is the index of the corresponding phase,

j is the rank of the harmonic for the Fourier series decomposition, the fundamental being of rank equal to 1, and k is an index of a voltage period $P_{voltage}$ during which the value of the electrical quantity (X) is measured.

FIG.1

<u>FIG.2</u>

FIG.3

EP 3 037 832 B1

27

**FIG.4**

Initialisation et ouverture d'une fenêtre glissante de réception — 300

Réception du premier message M1 — 310

Adaptation de la fréquence d'échantillonage — 315

Synchronisation temporelle avec le premier dispositif — 320

Mesure de l'intensité — 330

Compression de l'intensité mesurée, calcul des paramètres de surveillance — 340

Elaboration du deuxième message M2 — 350

Emission du deuxième message M2 selon un mécanisme de jeton distribué — 360

## FIG.5

Réception des messages M'1, M2    400

Horodatage et stockage des valeurs reçues    410

Calcul de l'énergie électrique
et des puissances    420

Affichage des grandeurs
mesurées et calculées    430

Communication des grandeurs mesurées
et calculées à un serveur distant    440

## FIG.6

M1

| Préambule<br>4 octets | SFD<br>1 octet | PHD<br>1 octet | Données<br>n octets | CRC<br>2 octets |
|---|---|---|---|---|

$D_r$    $D_f$    $D_m$    $T_m$

$T_e$    $T_r$

Emission radio par émetteur    IT par récepteur

## FIG.7

FIG.8

FIG.9

EP 3 037 832 B1

## RÉFÉRENCES CITÉES DANS LA DESCRIPTION

**Documents brevets cités dans la description**

- WO 2013017663 A1
- EP 2685267 A1
- FR 2991057 A1
- FR 3007143 A1
- US 6734658 B1